(19)

Europäisches
Patentamt

European
Patent Office

Office européen
des brevets

(11) **EP 3 102 961 B1**

(12) **EUROPÄISCHE PATENTSCHRIFT**

(45) Veröffentlichungstag und Bekanntmachung des
Hinweises auf die Patenterteilung:
**07.06.2017** **Patentblatt 2017/23**

(21) Anmeldenummer: **14815243.2**

(22) Anmeldetag: **18.12.2014**

(51) Int Cl.:
**G01R 35/00** (2006.01)    **G01R 19/25** (2006.01)
**G01R 27/32** (2006.01)

(86) Internationale Anmeldenummer:
**PCT/EP2014/003424**

(87) Internationale Veröffentlichungsnummer:
**WO 2015/117634 (13.08.2015 Gazette 2015/32)**

(54) **ZEITBEREICHSMESSVERFAHREN MIT KALIBRIERUNG IM FREQUENZBEREICH**

TIME DOMAIN MEASURING METHOD WITH CALIBRATION IN THE FREQUENCY RANGE

PROCÉDÉ DE MESURE DANS LE DOMAINE TEMPOREL AVEC CALIBRATION DANS LE DOMAINE
FRÉQUENTIEL

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **06.02.2014   DE 102014001585**

(43) Veröffentlichungstag der Anmeldung:
**14.12.2016   Patentblatt 2016/50**

(73) Patentinhaber: **Rosenberger
Hochfrequenztechnik GmbH & Co. KG
83413 Fridolfing (DE)**

(72) Erfinder: **ZIETZ, Christian
59555 Lippstadt (DE)**

(74) Vertreter: **Zeitler Volpert Kandlbinder
Patent- und Rechtsanwälte Partnerschaft mbB
Herrnstrasse 44
80539 München (DE)**

(56) Entgegenhaltungen:
**WO-A1-2013/143650       WO-A2-03/048791
WO-A2-2008/016699      US-A1- 2008 048 674**

- **ARKADIUSZ LEWANDOWSKI ET AL:
"Covariance-Based Vector-Network-Analyzer
Uncertainty Analysis for Time and
Frequency-Domain Measurements", IEEE
TRANSACTIONS ON MICROWAVE THEORY AND
TECHNIQUES, IEEE SERVICE CENTER,
PISCATAWAY, NJ, US, Bd. 58, Nr. 7, 1. Juli 2010
(2010-07-01), Seiten 1877-1886, XP011311287,
ISSN: 0018-9480**
- **CLEMENT T S ET AL: "Calibration of Sampling
Oscilloscopes With High-Speed Photodiodes",
IEEE TRANSACTIONS ON MICROWAVE THEORY
AND TECHNIQUES, IEEE SERVICE CENTER,
PISCATAWAY, NJ, US, Bd. 54, Nr. 8, 1. August
2006 (2006-08-01) , Seiten 3173-3181,
XP001545193, ISSN: 0018-9480, DOI:
10.1109/TMTT.2006.879135**

**Beschreibung**

Die Erfindung betrifft ein Verfahren zum Bestimmen einer elektrischen Spannung u(t) und/oder eines elektrischen Stroms i(t) eines HF-Signals auf einer elektrischen Leitung in einer Kalibrierebene durch Messung im Zeitbereich mit einer Zeitbereichsmesseinrichtung, wobei die Kalibrierebene derart ausgebildet ist, dass an der Kalibrierebene ein Messobjekt elektrisch anschließbar ist. In einem Messschritt wird mit einem Richtkoppler ein erster Anteil $v_3(t)$ eines ersten HF-Signals, welches ausgehend von einem Signaleingang in Richtung der Kalibrierebene durch den Richtkoppler läuft, ausgekoppelt, der Zeitbereichsmesseinrichtung an einem ersten Messeingang zugeführt und dort in einer ersten Messebene vermessen, und ein zweiter Anteil $v_4(t)$ eines zweiten HF-Signals, welches ausgehend von der Kalibrierebene in Richtung des Signaleingangs durch den Richtkoppler läuft, wird ebenfalls mit dem Richtkoppler ausgekoppelt, der Zeitbereichsmesseinrichtung an einem zweiten Messeingang zugeführt und dort in einer zweiten Messebene vermessen. Die mit der Zeitbereichsmesseinrichtung gemessenen Signalanteile $v_3(t)$, $v_4(t)$ werden mittels einer ersten mathematischen Operation in den Frequenzraum als Wellengrößen $V_3(f)$ und $V_4(f)$ überführt, dann werden aus den Wellengrößen $V_3(f)$ und $V_4(f)$ unter Verwendung von Kalibrierparametern absolute Wellengrößen $a_2$ und $b_2$ im Frequenzraum in der Kalibrierebene bestimmt, und schließlich werden die berechneten absoluten Wellengrößen $a_2$ und $b_2$ mittels einer zweiten mathematischen Operation in die elektrische Spannung u(t) und/oder den elektrischen Strom i(t) des HF-Signals im Zeitbereich in der Kalibrierebene umgerechnet. Die Kalibrierparameter werden in einem vorausgehenden Kalibrierungsschritt derart bestimmt, dass sie die Wellengrößen $V_3(f)$ und $V_4(f)$ in den Messebenen mit den Wellengrößen $a_2$ und $b_2$ in der Kalibrierebene mathematisch verknüpfen.

Zu den wichtigsten Messaufgaben der Hochfrequenz- und Mikrowellentechnik gehört die Messung von Reflexionsfaktoren oder allgemein - bei Mehrtoren - die Messung von Streuparametern. Durch die Streuparameter wird das linear beschreibbare Netzwerkverhalten eines Messobjekts (DUT: "device under test") charakterisiert. Häufig interessiert man sich nicht nur für die Streuparameter bei einer einzigen Messfrequenz, sondern für deren Frequenzabhängigkeit über ein endlich breites Messband. Das zugehörige Messverfahren bezeichnet man als Netzwerkanalyse. Je nach der Bedeutung der Phaseninformation bei der jeweiligen Messaufgabe kann man die Streuparameter entweder nur dem Betrage nach oder auch komplex messen. Im ersten Fall spricht man von skalarer, im zweiten Fall von vektorieller Netzwerkanalyse. Je nach Verfahren, Torzahl und Messfrequenzbereich ist der Netzwerkanalysator ein mehr oder weniger aufwendiges System aus Testsignalquelle und Empfängern, die nach dem Homodyn- oder dem Heterodynprinzip arbeiten. Weil die Messsignale durch Leitungen und sonstige Komponenten mit unbekannten und nichtidealen Eigenschaften zum Messobjekt und wieder zurückgeführt werden müssen, treten bei der Netzwerkanalyse neben zufälligen Fehlern auch systematische Fehler auf. Durch Kalibriermessungen, deren Ziel die Bestimmung möglichst vieler der unbekannten Parameter der Messeinrichtung ist, können die systematischen Fehler in gewissen Grenzen rückgängig gemacht werden. Es existieren hier sehr viele Verfahren und Strategien, die sich im Umfang des Fehlermodells und damit in Aufwand und Leistungsfähigkeit erheblich unterscheiden. (Uwe Siart; "Kalibrierung von Netzwerkanalysatoren"; 4. Januar 2012 (Version 1.51); http://www.siart.de/lehre/nwa.pdf).

Jedoch beschreiben derart kalibriert gemessene Streuparameter nur lineare, zeitinvariante Testobjekte vollständig. Eine Erweiterung der Streuparameter auf nichtlineare Testobjekte stellen die X-Parameter dar (D. Root et al: "X-Parameter: Das neue Paradigma zur Beschreibung nichtlinearer HF- und Mikrowellenbauelemente". In: tm - Technisches Messen Nr. 7-8, Vol. 77, 2010), die ebenfalls über der Frequenz definiert sind. Allerdings lässt sich jedes Testobjekt auch durch Messung der Ströme und Spannungen respektive der absoluten Wellengrößen an seinen Toren im Zeitbereich beschreiben. Die Messung im Zeitbereich erfasst inhärent sämtliche bspw. durch die Nichtlinearität hervorgerufenen weiteren Spektralanteile sowie die zeitliche Veränderung des Testobjekts oder dessen Eingangssignals. Auch eine derartige Zeitbereichsmessung bedarf der Kalibrierung. Zur Messung absoluter Größen können allerdings die oben genannten Kalibrierverfahren nicht unverändert angewendet werden, da sie nur die Bestimmung relativer Größen (Streuparameter) erlauben.

Aus der WO 03/048791 A2 ist ein Hochfrequenz-Schaltungsanalysator bekannt, mit dem Verstärkerschaltungen getestet werden. Ein Mikrowellen-Transition-Analysator (MTA) mit zwei Eingängen misst über Signalpfade und Ports im Zeitbereich zwei unabhängige Signalwellenformen, wie beispielsweise hinlaufende und rücklaufende Welle, bei angeschlossener, zu prüfender Verstärkerschaltung. Die gemessenen Wellen werden mittels Kalibrierdaten nachbearbeitet, um den Einfluss des Messsystems auf die Wellen zwischen den Ports der Verstärkerschaltung und den Eingangsports des MTA zu kompensieren. Zum Bestimmen der Kalibrierdaten wird ebenfalls der MTA verwendet, welcher Signale im Zeitbereich bei angeschlossenen Kalibrierstandards misst. Diese Signale im Zeitbereich werden mittels FFT in den Frequenzbereich umgesetzt und anschließend werden die Kalibriedaten bestimmt. Da nur periodische Signale im Zeitbereich gemessen werden sollen, werden die Signale vor der Messung auf eine niederfrequente Zwischenfrequenz umgesetzt.

In der Druckschrift WO2013/143650 A1 ist ein Zeitbereichsmessverfahren mit Kalibrierung im Frequenzbereich gemäß dem Oberbegriff von Anspruch 1 beschrieben. Bei diesem Verfahren werden eine elektrische Spannung und/oder ein elektrischer Strom eines Hochfrequenzsignals im Zeitbereich auf einer elektrischen Leitung in einer Kalibrierebene gemessen. Hierzu wird ein Richtungskoppler in die Zuleitung des Messsignals zu dem Messobjekt eingefügt, und ein erster Anteil des ersten HF-Signals, das von dem Signaleingang des Richtkopplers durch den Richtkoppler in Richtung auf das Messobjekt läuft, wird über den ersten Messausgang des Richtkopplers ausgekoppelt und mit der Zeitbereichsmesseinrichtung vermessen, und ein zweiter Anteil des von dem Messobjekt rücklaufenden HF-Signals, das in der Gegenrichtung durch den Richtkoppler läuft, wird über den zweiten Messausgang des Richtkopplers ausgekoppelt und mit der Zeitbereichsmesseinrichtung vermessen. Die gemessenen Signalanteile werden in den Frequenzbereich transformiert, um Wellengrößen zu erhalten. Mithilfe von zuvor bestimmten Kalibrierparametern werden aus diesen, in den Messebenen bestimmten Wellengrößen entsprechende W ellengrößen in der Kalibrierebene im Frequenzraum bestimmt, und diese Wellengrößen werden anschließend wiederum in den Zeitbereich rücktransformiert, so dass sie die zu bestimmenden Signalgrößen u(t) und/oder i(t) im Zeitbereich in der Kalibrierebene angeben.

Die Kalibrierparameter, die die Wellengrößen in den Messebenen mit den Wellengrößen in der Kalibrierebene verknüpfen, werden mithilfe einer Kalibriervorrichtung in einem vorausgehenden Kalibrierschritt frequenzabhängig bestimmt, wobei der Kalibrierschritt in der genannten Druckschrift WO2013/143650 A1 ausführlich beschrieben ist. Diese Kalibrierparameter sind in Form einer Fehlermatrix $\mathbf{E} = \begin{pmatrix} e_{00} & e_{01} \\ e_{10} & e_{11} \end{pmatrix}$ darstellbar, mit der die Wellengrößen $a_2$, $b_2$ in der Kalibrierebene wie folgt aus Wellengrößen $b_4$, $b_3$ in den Messebenen berechnet werden können:

$$\begin{pmatrix} b_4 \\ b_2 \end{pmatrix} = \begin{pmatrix} e_{00} & e_{01} \\ e_{10} & e_{11} \end{pmatrix} \begin{pmatrix} b_3 \\ a_2 \end{pmatrix}.$$ Der Offenbarungsgehalt der WO2013/143650 A1 wird hinsichtlich der Bestimmung der Kalibrierparameter hiermit durch ausdrückliche Inbezugnahme in diese Beschreibung mit aufgenommen.

Es hat sich allerdings herausgestellt, dass die mittels dieses Verfahrens bestimmten Signalgrößen in der Kalibrierebene nicht immer exakt sind und von der verwendeten Zeitbereichsmesseinrichtung abhängen können.

Aus der WO-A-2013 143 650 ist ein Verfahren zum Bestimmen einer elektrischen Spannung und/oder eines elektrischen Stroms eines HF-Signals auf einer elektrischen Leitung in einer Kalibrierebene durch Messung im Zeitbereich mit einer Zeitbereichsmesseinrichtung bekannt, wobei an der Kalibrierebene ein Messobjekt elektrisch an-schließbar ist. In einem Messschritt mit einem Richtkoppler wird ein erster Anteil eines ersten HF-Signals, welches ausgehend von einem Signaleingang in Richtung der Kalibrierebene durch den Richtkoppler läuft, ausgekoppelt, der Zeitbereichsmesseinrichtung an einem ersten Messeingang zugeführt und dort vermessen. Ein zweiter Anteil eines zweiten HF-Signals, welches ausgehend von der Kalibrierebene in Richtung des Signaleingangs durch den Richtkoppler läuft, wird der Zeitbereichsmesseinrichtung an einem zweiten Messeingang zugeführt und dort vermessen. Die Signalanteile werden mittels einer ersten mathematischen Operation in den Frequenzraum als Wellengrößen überführt, dann aus den Wellengrößen unter Verwendung von Kalibrierparametern absolute Wellengrößen und im Frequenzraum in der Kalibrie-bene bestimm, und schließlich die bestimmten absoluten Wellengrößen mittels einer zweiten mathematischen Operation in die elektrische Spannung und/oder den elektrischen Strom des HF-Signals im Zeitbereich in der Kalibrierebene umgerechnet werden, wobei die Kalibrierparameter die Wellengrößen mit den absoluten Wellengrößen in der Kalibrierebene mathematisch verknüpfen.

Das Dokument Clement T. S. et al: "Calibartion of Sampling Oscilloscopes With High-Speed Photodiodes", IEEE TRANSACTIONS ON MICROWAVE THEORY AND TECHNIQUES, IEEE SERVICE CENTER, PISCATAWAY, NJ, US, Bd. 54, Nr. 8, 1. August 2006 (2006-08-01), Seiten 3173 - 3181, XP-001545193, ISSN: 0018 - 9480, DOI: 10.1109/TMTT.2006.879135 Kapitel: C. Impedance Mismatch Correction offenbart, Reflexionskoeffizienten einer Fotodiode und eines Oszilloskops mit Hilfe eines Netzwerkanalysators zu bestimmen.

Das Dokument Arkadiusz Lewandowski et al: "Covariance-Based Vector-Network-Analyzer Uncertainty Analysis for Time and Frequency-Domain Measurements", IEEE TRANSACTIONS ON MICROWAVE THEORY AND TECHNIQUES, IEEE SERVICE CENTER, PISCATAWAY, NJ, US, Bd. 58, Nr. 7, 1. Juli 2010 (2010-07-01), Seiten 1877 - 1886, XP-011311287, ISSN: 0018 - 9480, Kapitel: IV. Propagating Covarince-Matrix-Based Uncertainties Unterkapitel; A Mismatched-Correcting Waveform Measurements offenbart, eine Ausgangsimpedanz der Signalquelle und eine Eingangsimpedanz des Oszilloskops mit einem Netzwerkanalysator zu bestimmen, wobei die verwendete Gleichung nur für niedrige Frequenzen gilt, jedoch nicht für höhere Frequenzen

Das Dokument WO-A-2008 016699 offenbart für verschieden Bauteile, wie Messspitzen oder Leitungen, verschiedene Parameter zu bestimmen.

Der Erfindung liegt in Anbetracht dieses Problems die Aufgabe zugrunde, ein verbessertes Messverfahren für hochfrequente Ströme und Spannungen respektive absolute Wellengrößen im Zeitbereich anzugeben.

Diese Aufgabe wird erfindungsgemäß durch eine Weiterbildung des eingangs beschriebenen Verfahrens nach Anspruch 1 gelöst, die im Wesentlichen dadurch gekennzeichnet ist, dass der erste Messeingang der Zeitbereichsmesseinrichtung einen bekannten (komplexwertigen) Reflexionsfaktor $\Gamma_3 \neq 0$ hat und/oder der zweite Messeingang der Zeitbereichsmesseinrichtung einen bekannten (komplexwertigen) Reflexionsfaktor $\Gamma_4 \neq 0$ hat, wobei in dem Kalibrierschritt die Kalibrierparameter $e_{00,r}$, $e_{01,r}$, $e_{10,r}$, $e_{11,r}$ mithilfe einer Kalibriervorrichtung in Abhängigkeit von der Frequenz f und in Abhängigkeit von dem Reflexionsfaktor an zumindest einem der Messeingänge der Zeitbereichsmesseinrichtung bestimmt werden, und die Wellengrößen $a_2$ und $b_2$ in dem Messschritt unter Verwendung der Kalibrierparameter $e_{00,r}(\Gamma_3, \Gamma_4)$, $e_{01,r}(\Gamma_3, \Gamma_4)$, $e_{10,r}(\Gamma_3, \Gamma_4)$, $e_{11,r}(\Gamma_3, \Gamma_4)$ aus den Wellengrößen $V_3(f)$ und $V_4(f)$ bestimmt werden.

Die Erfindung geht auf die Erkenntnis zurück, dass das in der Druckschrift WO2013/143650 A1 beschriebene Verfahren nur dann exakte Ergebnisse liefert, wenn die beiden Messeingänge der Zeitbereichsmesseinrichtung reflexionsfrei abgeschlossen sind. Bei der Kalibrierung wurde nämlich davon ausgegangen, dass die Kalibriereinrichtung bereits zuvor an den verwendeten Messtoren kalibriert ist und sich somit ideal verhält. Daher erhält man Fehlermatrizen **E** und **I** für eine ideale Anpassung der Messtore der Kalibriereinrichtung. Hingegen hängen die Kalibrierparameter, die bei dem Messschritt für eine exakte Messung benötigt werden, von den Reflexionsfaktoren $\Gamma_3$ und $\Gamma_4$ an den Messeingängen der Zeitbereichsmesseinrichtung ab. Die herkömmliche Fehlermatrix **E** führt also nur dann zu exakten Ergebnissen, wenn für die Messeingänge $\Gamma_3 = \Gamma_4 = 0$ gilt.

Erfindungsgemäß können dagegen beliebige Zeitbereichsmesseinrichtungen für die Messung im Zeitbereich an die Messausgänge des Richtkopplers angeschlossen werden, da die Kalibrierparameter in Abhängigkeit von den Reflexionsfaktoren an den Messeingängen der Zeitbereichsmesseinrichtung ermittelt werden. Die Reflexionsfaktoren $\Gamma_3$ und $\Gamma_4$ der Messeingänge der Zeitbereichsmesseinrichtung sind bei der Ermittlung der Spannung und/oder des Stroms in dem Messschritt bekannt bzw. durch gesonderte Messung bestimmbar, so dass als Kalibrierparameter die frequenzabhängigen $e_{00,r}(\Gamma_3, \Gamma_4)$, $e_{01,r}(\Gamma_3, \Gamma_4)$, $e_{10,r}(\Gamma_3, \Gamma_4)$, $e_{11,r}(\Gamma_3, \Gamma_4)$ verwendbar sind.

Es hat sich bei dem Kalibrierschritt als zweckmäßig erwiesen, den Signaleingang des Richtkopplers mit einem ersten Messtor S1, den ersten Messausgang des Richtkopplers mit einem zweiten Messtor S3 und den zweiten Messausgang des Richtkopplers mit einem dritten Messtor S4 der Kalibriervorrichtung zu verbinden. Zugleich können an einen mit der Kalibrierebene S2 verbundenen Signalausgang des Richtkopplers ein oder mehrere Messstandards mit bekannten Reflexionsfaktoren $\Gamma_k$ angeschlossen werden.

Die Bestimmung der Wellengrößen $a_2$ und $b_2$ in der Kalibrierebene aus den Wellengrößen $b_3$ und $b_4$ in den Messebenen ist dann besonders schnell und zuverlässig möglich, wenn die Kalibrierparameter $e_{00,r}$, $e_{01,r}$, $e_{10,r}$, $e_{11,r}$ die an dem zweiten Messtor S3 einlaufende Wellengröße $b_3$ und die an dem dritten Messtor S4 einlaufende Wellengröße $b_4$ wie folgt mit den ein- und auslaufenden Wellengrößen $b_2$, $a_2$ in der Kalibrierebene S2 verknüpfen:

$$\begin{pmatrix} b_4 \\ b_2 \end{pmatrix} = \begin{pmatrix} e_{00,r} & e_{01,r} \\ e_{10,r} & e_{11,r} \end{pmatrix} \begin{pmatrix} b_3 \\ a_2 \end{pmatrix}.$$

Die Bestimmung der Kalibrierparameter $e_{00,r}$, $e_{01,r}$, $e_{10,r}$, $e_{11,r}$ kann erfindungsgemäß dadurch vereinfacht werden, dass zunächst die Streuparameter $S_{xy}$ (x=1-4, y=1-4) der Streumatrix **S** des Viertors mit den Toren S1, S2, S3, S4, insbesondere die Streumatrix **S** des Richtkopplers samt Zuleitungen, mithilfe der Kalibriereinrichtung bestimmt werden, und anschließend aus den Streuparametern $S_{xy}$ die Kalibrierparameter $e_{00,r}$, $e_{01,r}$, $e_{10,r}$, $e_{11,r}$ in Abhängigkeit von den Reflexionsfaktoren der Zeitbereichsmesseinrichtung $\Gamma_3$ und $\Gamma_4$ bestimmt werden.

Mit anderen Worten weist das Viertor, dessen Streuparameter $S_{xy}$ bestimmt werden, folgende vier Tore auf:

- ein erstes Tor S1, das den Signaleingang des Richtkopplers darstellt und das bei der Kalibrierung mit dem ersten Messtor der Kalibriereinrichtung verbunden wird,
- ein zweites Tor S2, das mit dem Signalausgang des Richtkopplers verbunden ist und die Kalibrierebene darstellt, wobei an dem zweiten Tor S2 die Messobjekte bzw. die Messstandards anschließbar sind,
- ein drittes Tor S3, das den ersten Signalausgang des Richtkopplers darstellt bzw. damit verbunden ist, und das bei der Kalibrierung mit dem zweiten Messtor der Kalibriereinrichtung verbunden wird,
- ein viertes Tor S4, das den zweiten Signalausgang des Richtkopplers darstellt bzw. damit verbunden ist, und das bei der Kalibrierung mit dem dritten Messtor der Kalibriereinrichtung verbunden wird.

Dieses Viertor ist bei dem Kalibrierschritt und bei dem Messschritt in unveränderter Form vorhanden (bzw. Änderungen an der Zuleitung zum Richtkoppler wirken sich nicht aus, da die von der Zuleitung abhängigen Terme bei der Bestimmung der $e_{xy}$ wegfallen), so dass die bei der Kalibrierung bestimmten Streuparameter $S_{xy}$ des Viertors auch bei dem Messschritt noch korrekt sind und zur Bestimmung der korrigierten Fehlermatrix **$E_r$** verwendet werden können. In diesem Zusammenhang ist hervorzuheben, dass die Streuparameter eines n-Tors per Definition unabhängig von der Außenbeschaltung sind. Hingegen hängt die Fehlermatrix **$E_r$**, deren Terme während der Messung benötigt werden, von den Reflexionsfaktoren an den Messtoren der Zeitbereichsmesseinrichtung ab, nicht jedoch von den Eigenschaften der Zuleitung zwischen dem Signalgenerator und dem Signaleingang des Richtkopplers.

Mit anderen Worten gilt die (unkorrigierte) Fehlermatrix **E**, wie sie in der Druckschrift WO2013/143650 A1 bestimmt wird, nur für $\Gamma_3 = \Gamma_4 = 0$, was an einer allgemeinen Zeitbereichsmesseinrichtung nicht gewährleistet ist. Hierdurch kann die Messgenauigkeit bei dem Verfahren der Druckschrift WO2013/143650 A1 beeinträchtigt werden.

Gemäß dem erfindungsgemäßen Verfahren kann jedoch aus den Streuparametern $S_{xy}$ unter Verwendung der bekannten Reflexionsfaktoren $\Gamma_3$, $\Gamma_4$ der Zeitbereichsmesseinrichtung eine korrigierte Fehlermatrix $E_r$ wie folgt bestimmt werden:

$$e_{00,r} = \frac{S_{41} - \Gamma_3 S_{33} S_{41} + \Gamma_3 S_{31} S_{43}}{S_{31} + \Gamma_4 S_{34} S_{41} - \Gamma_4 S_{31} S_{44}},$$

$$e_{01,r} = \frac{S_{31} S_{42} - S_{32} S_{41}}{S_{31} + \Gamma_4 S_{34} S_{41} - \Gamma_4 S_{31} S_{44}},$$

$$e_{10,r} = \frac{\Gamma_4 S_{24} S_{41} + \Gamma_3 (\Gamma_4 S_{24} (S_{31} S_{43} - S_{33} S_{41}) + S_{23} (S_{31} + \Gamma_4 S_{34} S_{41} - \Gamma_4 S_{31} S_{44}))}{S_{31} + \Gamma_4 S_{34} S_{41} - \Gamma_4 S_{31} S_{44}}$$
$$+ \frac{S_{21} (1 - \Gamma_4 S_{44} - \Gamma_3 (S_{33} + \Gamma_4 S_{34} S_{43} - \Gamma_4 S_{33} S_{44}))}{S_{31} + \Gamma_4 S_{34} S_{41} - \Gamma_4 S_{31} S_{44}},$$

$$e_{11,r} = \frac{\Gamma_4 S_{24} (-S_{32} S_{41} + S_{31} S_{42}) + S_{22} (S_{31} + \Gamma_4 S_{34} S_{41} - \Gamma_4 S_{31} S_{44}) - S_{21} (S_{32} + \Gamma_4 S_{34} S_{42} - \Gamma_4 S_{32} S_{44})}{S_{31} + \Gamma_4 S_{34} S_{41} - \Gamma_4 S_{31} S_{44}}.$$

Vorzugsweise werden die Streuparameter $S_{xy}$ durch Messung der Größen $\widetilde{S_{11}} = b_1/a_1$, $\widetilde{S_{33}} = b_3/a_3$, $\widetilde{S_{44}} = b_4/a_4$, $\widetilde{S_{31}} = b_3/a_1$ o der $\widetilde{S_{13}} = b_1/a_3$, $\widetilde{S_{41}} = b_4/a_1$ o der $\widetilde{S_{14}} = b_1/a_4$, $\widetilde{S_{43}} = b_4/a_3$ oder $\widetilde{S_{34}} = b_3/a_4$ an den Messtoren S1, S3, S4 der Kalibriervorrichtung bestimmt, wobei ein oder mehrere Messstandards wie etwa Match M, Open O und/oder Short S mit den bekannten Reflexionsfaktoren $\Gamma_M$, $\Gamma_O$, $F_S$ als Messobjekte in der Kalibrierebene S2 angeschlossen werden, wobei $a_1$, $a_3$, $a_4$ an den jeweiligen Messtoren S1, S3, S4 einlaufende Wellengrößen und $b_1$, $b_3$, $b_4$ an den jeweiligen Messtoren S1, S3, S4 auslaufende Wellengrößen sind.

Eine Bestimmung unter Verwendung anderer Messstandards ist alternativ gleichermaßen möglich. Mit anderen Worten werden für die einzelnen Messstandards, soweit erforderlich, die an den drei Messtoren der Kalibriereinrichtung jeweils ein- und auslaufenden Wellengrößen frequenzabhängig vermessen, wobei aus diesen Messgrößen alle 16 Parameter der Streumatrix S des Viertors mittels der folgenden Gleichungen bestimmt werden können.

$$S_{11} = i_{00}$$

$$S_{21} = i_{10}$$

$$S_{12} = i_{01}$$

$$S_{22} = i_{11}$$

$$S_{13} = S_{31} = \tilde{S}_{31} - \frac{\Gamma_{DUT} i_{10}}{1 - \Gamma_{DUT} i_{11}} S_{32},$$

$$S_{14} = S_{41} = \tilde{S}_{41} - \frac{\Gamma_{DUT} i_{10}}{1 - \Gamma_{DUT} i_{11}} S_{42}.$$

$$S_{23} = S_{32} = \frac{-(e_{11} - i_{11})(\Gamma_{\mathrm{DUT}} i_{11} - 1)\check{S}_{31}}{(e_{11}\Gamma_{\mathrm{DUT}} - 1)i_{10}},$$

$$S_{24} = S_{42} = \frac{(\Gamma_{\mathrm{DUT}} i_{11} - 1)(e_{01} i_{10} + (i_{11} - e_{11})\check{S}_{41})}{(e_{11}\Gamma_{\mathrm{DUT}} - 1)i_{10}},$$

$$S_{33} = \tilde{S}_{33} - \frac{\Gamma_{\mathrm{DUT}} S_{23}}{1 - \Gamma_{\mathrm{DUT}} i_{11}} \cdot S_{32}.$$

$$S_{43} = S_{34} = \tilde{S}_{34} - \frac{\Gamma_{\mathrm{DUT}} S_{24}}{1 - \Gamma_{\mathrm{DUT}} i_{11}} \cdot S_{32}.$$

$$S_{44} = \tilde{S}_{44} - \frac{\Gamma_{\mathrm{DUT}} S_{24}}{1 - \Gamma_{\mathrm{DUT}} i_{11}} \cdot S_{42},$$

wobei

$\Gamma_{\mathrm{DUT}}$ der bekannte Reflexionsfaktor des jeweils verwendeten Kalibrierstandards ist, $\widetilde{S_{xy}}$ die an den Messtoren S1, S3, S4 messbaren $b_x/a_y$ sind,

und:

$$i_{00} = \tilde{S}_{11,M},$$

$$e_{00} = \frac{\tilde{S}_{41,M}}{\tilde{S}_{31,M}},$$

$$i_{10}i_{01} = \frac{(\Gamma_O - \Gamma_S)(\tilde{S}_{11,O} - \tilde{S}_{11,M})(\tilde{S}_{11,S} - \tilde{S}_{11,M})}{\Gamma_O\Gamma_S(\tilde{S}_{11,O} - \tilde{S}_{11,S})},$$

$$e_{10}e_{01} = \frac{(\Gamma_O - \Gamma_S)(\frac{\tilde{S}_{41,O}}{\tilde{S}_{31,O}} - \frac{\tilde{S}_{41,M}}{\tilde{S}_{31,M}})(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

$$i_{11} = \frac{\Gamma_S(\tilde{S}_{11,O} - \tilde{S}_{11,M}) - \Gamma_O(\tilde{S}_{11,S} - \tilde{S}_{11,M})}{\Gamma_O\Gamma_S(\tilde{S}_{11,O} - \tilde{S}_{11,S})},$$

$$e_{11} = \frac{\Gamma_S(\frac{\tilde{S}_{41,O}}{\tilde{S}_{31,O}} - \frac{\tilde{S}_{41,M}}{\tilde{S}_{31,M}}) - \Gamma_O(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

wobei $\Gamma_O$, $\Gamma_S$, $\Gamma_M$ die bekannten Reflexionsfaktoren der Kalibrierstandards Open, Short und Match sind, und $\widetilde{S_{xy,K}}$ die an den Messtoren S1, S3, S4 messbaren $b_x/a_y$ bei angeschlossenem Kalibrierstandard K sind.

Diese Gleichungen sind lediglich als ein beispielhafter Weg zum Ermitteln der Streuparameter $S_{xy}$ des Viertors zu verstehen. Alternative Rechenwege sind gleichermaßen verwendbar. Der genannte Weg hat jedoch den Vorteil, dass auf die ohnehin bereits bestimmten Einträge der Fehlermatrizen **E** und **I** (siehe Druckschrift WO2013/143650 A1) zurückgegriffen werden kann, ohne dass zusätzliche Messungen durchgeführt und/oder andere Messstandards angeschlossen werden müssen. Der Fachmann wird bspw. erkennen, dass die $S_{xy}$ auch ohne Rückgriff auf die $e_{xy}$ und/oder die $i_{xy}$ alleine aus den direkt messbaren $\widetilde{S_{xy,K}}$ bestimmbar sind.

Einen besonders einfachen Messaufbau mit kostengünstigen elektronischen Komponenten erzielt man dadurch, dass die Signalgrößen $v_3(t)$ und $v_4(t)$ jeweils eine elektrische Spannung sind.

Einen besonders einfachen und funktionssicheren Messaufbau erzielt man dadurch, dass als Zeitbereichsmesseinrichtung ein Oszilloskop verwendet wird, beispielsweise ein digitales Oszilloskop, welches zur Zeit- und Wertbereichsquantisierung des Signals verwendet werden kann.

Eine besonders schnelle und gleichzeitig genaue Umsetzung zwischen Frequenzbereich und Zeitbereich, die mit geringem Rechenaufwand durchgeführt werden kann, erzielt man dadurch, dass die erste mathematische Operation eine FFT (Fast Fourier Transformation) und die zweite mathematische Operation eine inverse FFT (IFFT - Inverse Fast Fourier Transformation) ist.

Die Transformierung der gemessenen Signalanteile $v_3(t)$ und $v_4(t)$ von dem Zeitbereich in den Frequenzbereich kann bspw. gemäß den folgenden Rechenschritten erfolgen:

$$\{V_3(l \cdot \Delta f)\} = FFT\{v_3(k \cdot \Delta t)\}$$

$$\{V_4(l \cdot \Delta f)\} = FFT\{v_4(k \cdot \Delta t)\}$$

$$mit\ k = 0,1,\dots,N-1$$

$$und\ l = 0,1,\dots,\frac{N-1}{2},$$

wobei N eine Anzahl von Datenpunkten ist, $\Delta f$ eine Frequenzschrittweite mit $\Delta f = 2f_{max}/(N - 1)$ ist, $\Delta t$ eine zeitliche Schrittweite ist, wobei $f_{max}$ die maximale Frequenz bezeichnet, für die Kalibrierdaten vorliegen. Da es sich bei den gemessenen Spannungen um reelle Größen handelt, und damit das resultierende Fourier-Spektrum als symmetrisch um f=0 zu erwarten ist, ist die Betrachtung der Spektralanteile für $f \geq 0$ ausreichend.

Aus den Spannungen $V_3$ und $V_4$ werden die Wellengrößen $b_3$ und $b_4$ vorzugsweise wie folgt bestimmt:

$$b_3 = \frac{V_3}{(1+\Gamma_3)\sqrt{Z_0}}$$

$$b_4 = \frac{V_4}{(1+\Gamma_4)\sqrt{Z_0}},$$

wobei $Z_0$ die Impedanz bezeichnet, bezüglich derer die Reflexionsfaktoren $\Gamma_3$, $\Gamma_4$ bestimmt wurden. Üblicherweise ist $Z_0 = 50\ \Omega$.

Aus den Wellengrößen $b_3$, $b_4$ werden mithilfe der Kalibrierparameter ($e_{00,r}(\Gamma_3, \Gamma_4)$, $e_{01,r}(\Gamma_3, \Gamma_4)$, $e_{10,r}(\Gamma_3, \Gamma_4)$, $e_{11,r}(\Gamma_3, \Gamma_4)$) durch entsprechende Auflösung des Gleichungssystems $\begin{pmatrix} b_4 \\ b_2 \end{pmatrix} = \begin{pmatrix} e_{00,r} & e_{01,r} \\ e_{10,r} & e_{11,r} \end{pmatrix} \begin{pmatrix} b_3 \\ a_2 \end{pmatrix}$ die absoluten Wellengrößen $a_2$, $b_2$ in der Kalibrierebene bestimmt, und daraus die Spannung $V_2(f)$ und der Strom $I_2(f)$ in der Kalibrierebene mittels der folgenden Rechenschritte:

$$V_2 = \sqrt{Z_1}(a_2 + b_2)$$

$$I_2 = \sqrt{\frac{1}{Z_1}}(a_2 - b_2),$$

wobei $Z_1$ die Systemimpedanz in der Kalibrierebene bezeichnet.

Die Rücktransformierung der Spannung $V_2(f)$ und des Stroms $I_2(f)$ von dem Frequenzbereich in den Zeitbereich kann bspw. gemäß den folgenden Rechenschritten erfolgen:

$$\{u(k \cdot \Delta t)\} = IFFT\{V_2(l \cdot \Delta f)\},$$

$$\{i(k \cdot \Delta t)\} = IFFT\{I_2(l \cdot \Delta f)\}$$

$$mit\ k = 0,1,\ldots,N-1$$

$$und\ l = 0,1,\ldots,\frac{N-1}{2}.$$

Auch hierbei konnte ausgenutzt werden, dass es sich bei der resultierenden Spannung und dem resultierenden Strom um reelle Größen handelt, so dass ausschließlich die Frequenzanteile f>0 als Eingangsgrößen für die IFFT benötigt werden.

Es ergeben sich die gesuchten Messgrößen u(t) und i(t) in der Kalibrierebene.

Als Kalibriervorrichtung wird vorzugsweise ein vektorieller Netzwerkanalysator (VNA bzw. vektorieller NWA) mit zumindest drei Messtoren verwendet.

Wenn die Kalibrierparameter gemäß dem erfindungsgemäßen Verfahren im Kalibrierschritt bestimmt worden sind, kann anschließend im Messschritt die Spannung u(t) und/oder der Strom i(t) in der Kalibrierebene bestimmt werden, indem der erste Messausgang des Richtkopplers und der zweite Messausgang des Richtkopplers von der Kalibriervorrichtung getrennt und mit den Messeingängen der Zeitbereichsmesseinrichtung verbunden werden, während über den Signaleingang des Richtkopplers das erste HF-Signal zugeführt wird.

Die Erfindung wird im Folgenden anhand der Zeichnung näher erläutert. Diese zeigt in:

Fig. 1    eine schematische Darstellung eines Messaufbaus zum Ausführen eines Kalibrierschrittes des erfindungsgemäßen Verfahrens im Frequenzbereich,

Fig. 2    eine schematische Darstellung eines Messaufbaus zum Ausführen eines Messschrittes des erfindungsgemäßen Verfahrens im Zeitbereich,

Fig. 3    ein Signalflussdiagramm des Fehlerzweitors mit der Fehlermatrix $E$ zwischen Messausgängen $b_3$, $b_4$ des Richtkopplers und der Kalibrierebene (Fig. 3a) und ein Signalflussdiagramm des Fehlerzweitors $I$ zwischen dem Signaleingang des Richtkopplers und der Kalibrierebene (Fig. 3b) für den Messaufbau gemäß Fig. 1,

Fig. 4    eine Darstellung des Viertors mit der Streumatrix **S** (Richtkoppler samt Zuleitungen, Fig. 4a), eine Darstellung des Fehlerzweitors mit der Fehlermatrix $E$(Fig. 4b) und eine Darstellung des Fehlerzweitors $I$(Fig. 4c) für den Messaufbau gemäß Fig. 1,

Fig. 5    Beträge der Einträge $S_{xy}$ (x=1-4, y=1-4) der Streumatrix **S** eines beispielhaften Aufbaus in Abhängigkeit von der Frequenz (x-Achse: Frequenz f/Hz; y-Achse: /$S_{xy}$/ / dB); die durchgehenden Linien zeigen die im Kalibrierschritt bestimmten Werte; die Kreuze zeigen eine simulierte Referenz,

Fig. 6a    eine graphische Darstellung von im Kalibrierschritt des erfindungsgemäßen Verfahrens bestimmten Einträgen $e_{00}$, $e_{01}$, $e_{10}$ und $e_{11}$ der Fehlermatrix $E$ für den in Fig. 5 gezeigten beispielhaften Aufbau in Abhängigkeit von einer Frequenz f,

Fig. 6b    eine graphische Darstellung der Kalibrierparameter $e_{00,r}(\Gamma_3, \Gamma_4)$, $e_{01,r}(\Gamma_3, \Gamma_4)$, $e_{10,r}(\Gamma_3, \Gamma_4)$, $e_{11,r}(\Gamma_3, \Gamma_4)$ für den in Fig. 5 gezeigten beispielhaften Aufbau in Abhängigkeit von der Frequenz f unter Verwendung exem-

plarischer Reflexionsfaktoren $\Gamma_3$, $\Gamma_4$ der Messeingänge der Zeitbereichsmesseinrichtung,

Fig. 7a     eine graphische Darstellung einer in der Kalibrierebene mit dem erfindungsgemäßen Verfahren bestimmten elektrischen Spannung u(t) unter Verwendung der (korrigierten) Kalibrierparameter $e_{00,r}$, $e_{01,r}$, $e_{10,r}$, $e_{11,r}$ sowie unter Verwendung der (unkorrigierten) Kalibrierparameter $e_{00}$, $e_{01}$, $e_{10}$, $e_{11}$ für ein eingespeistes erstes HF-Signal, und

Fig. 7b     eine graphische Darstellung eines in der Kalibrierebene mit dem erfindungsgemäßen Verfahren bestimmten elektrischen Stroms i(t) unter Verwendung der (korrigierten) Kalibrierparameter $e_{00,r}$, $e_{01,r}$, $e_{10,r}$, $e_{11,r}$ sowie unter Verwendung der (unkorrigierten) Kalibrierparameter $e_{00}$, $e_{01}$, $e_{10}$, $e_{11}$ für ein eingespeistes erstes HF-Signal.

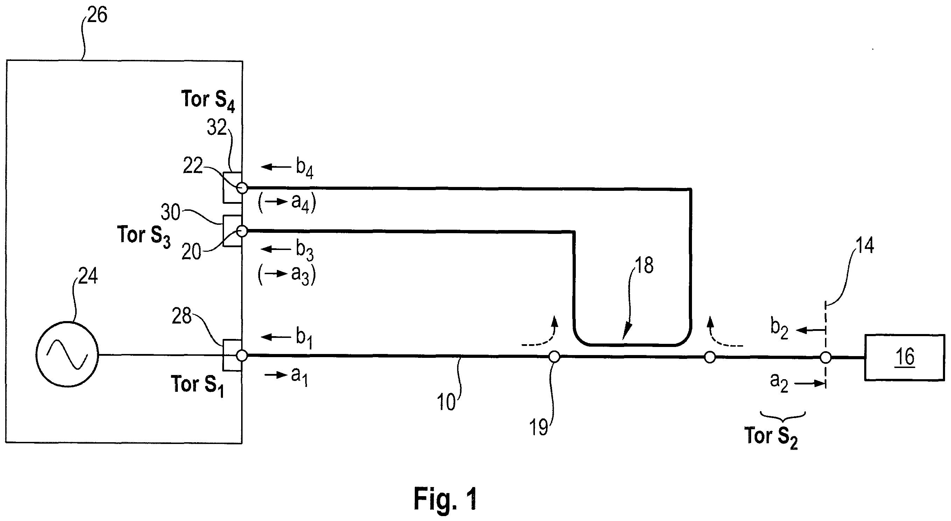

In Fig. 1 ist schematisch eine Anordnung zum Durchführen des Kalibrierschritts des erfindungsgemäßen Verfahrens dargestellt. Diese Anordnung weist einen Richtkoppler 18 mit einem Signaleingang 19 auf, der über eine Zuleitung 10 mit einem ersten Messtor S1 28 einer Kalibriervorrichtung 26 (vektorieller Netzwerkanalysator NWA) verbunden ist. Mit dem Signalausgang des Richtkopplers ist eine Kalibrierebene 14 verbunden. Die Kalibrierebene 14 ist derart ausgebildet, dass an der Kalibrierebene 14 ein Messobjekt (DUT - Device Under Test) 16 elektrisch verbindbar ist. Dieses DUT 16 ist beispielsweise ein Kalibrierstandard, eine zu testende elektronische Schaltung oder ein elektronisches Bauelement. Mit dem Richtkoppler 18 mit zwei Messausgängen 20, 22 wird ein Anteil eines ersten HF-Signals, welches innerhalb des Richtkopplers 18 vom Signaleingang 19 in Richtung der Kalibrierebene 14 läuft, und ein Anteil eines zweiten HF-Signals, welches innerhalb des Richtkopplers 18 von der Kalibrierebene 14 in Richtung des Signaleingangs 19 läuft, ausgekoppelt. Der erste Signalausgang 20 des Richtkopplers 18 ist mit einem zweiten Messtor S3 30 des NWA verbunden, und der zweite Signalausgang 22 des Richtkopplers 18 ist mit einem dritten Messtor S4 32 des NWA verbunden. Als Richtkoppler 18 ist jedes Bauelement geeignet, welches eine Richtschärfe aufweist, d.h. eine Unterscheidung des Anteils des ersten HF-Signals und des Anteils des zweiten HF-Signals ermöglicht.

Über das erste Messtor 28 wird ein Signal eingespeist. Die Kalibrierebene 14, die mit dem Signalausgang des Kopplers 18 verbunden ist, stellt das Tor S2 des zu vermessenden Viertors **S** mit den Toren S1 bis S4 dar, da an dieser Stelle das zu vermessende Messobjekt 16 anzuschließen ist. Deshalb wird in der folgenden Beschreibung die Kalibrierebene auch als Tor S2 bezeichnet. Das zu vermessende Viertor **S**, das vorliegend sowohl bei dem Kalibrierschritt als auch bei dem Messschritt zum Einsatz kommt, umfasst somit im Wesentlichen den Richtkoppler 18 samt Zuleitungen.

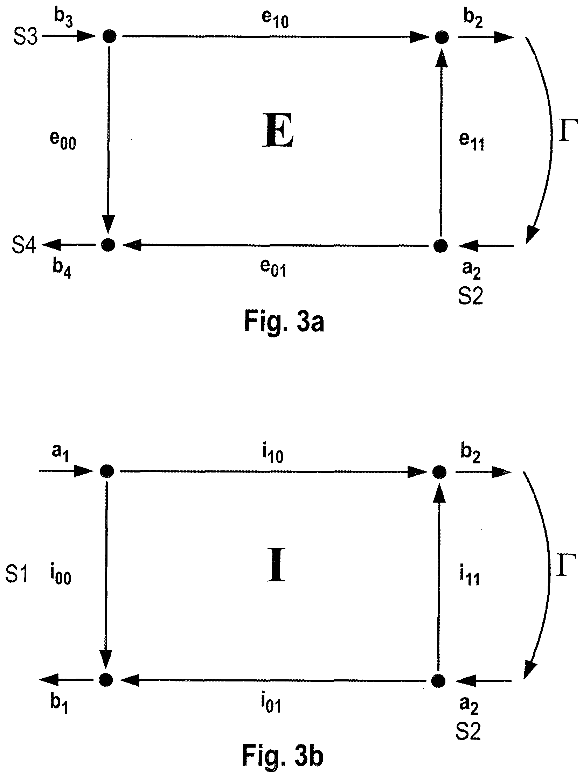

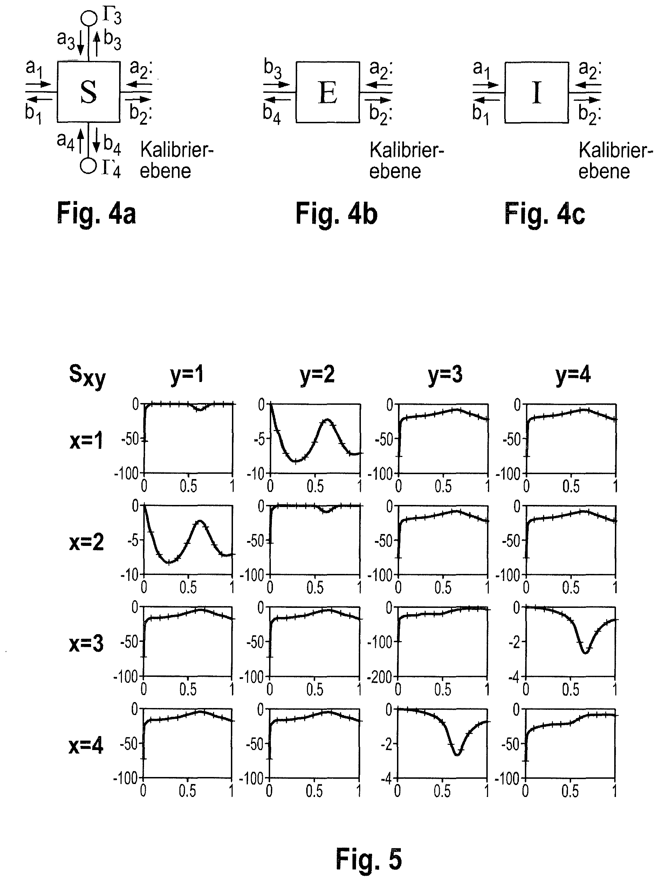

Das Viertor zwischen den drei Messtoren S1, S3 und S4 (28, 30, 32) des NWA sowie der Kalibrierebene S2 14 ist schematisch in Figur 4a dargestellt. Dieses Viertor lässt sich in zwei (Fehler-)Zweitore zerlegen, die schematisch in den Figuren 4b und 4c sowie als Signalflussdiagramme in den Figuren 3a und 3b dargestellt sind und die sich durch die beiden Fehlermatrizen **I** und **E** beschreiben lassen. Das Zweitor mit den auch als Fehlerkoeffizienten bezeichneten Einträgen $\begin{pmatrix} i_{00} & i_{01} \\ i_{10} & i_{11} \end{pmatrix}$ befindet sich zwischen dem Messtor S1 28 des NWA und der Kalibrierebene S2 14; das Zweitor mit den Fehlerkoeffizienten $\begin{pmatrix} e_{00} & e_{01} \\ e_{10} & e_{11} \end{pmatrix}$ befindet sich zwischen einerseits den Messtoren S3 30 und S4 32 des NWA 26, an denen die Messausgänge 20, 22 des Kopplers 18 angeschlossen sind, und andererseits der Kalibrierebene S2 14.

Zunächst sollen durch die Kalibrierung die vier Einträge $e_{xy}$ der (unkorrigierten) Fehlermatrix **E** bestimmt werden, die den Zusammenhang zwischen den Wellengrößen $a_2$ und $b_2$ in der Kalibrierebene und den durch den Richtkoppler 18 ausgekoppelten Wellengrößen $b_3$ und $b_4$ für das an den Messtoren S3 und S4 reflexionsfrei abgeschlossene Viertor **S** angeben. Der NWA 26 ist an seinen Messtoren folglich reflexionsfrei abgeschlossen. Anschließend werden mithilfe der Einträge $e_{xy}$ die (korrigierten) Kalibrierparameter $\begin{pmatrix} e_{00,r} & e_{01,r} \\ e_{10,r} & e_{11,r} \end{pmatrix}$ der (korrigierten) Fehlermatrix **E_r** bestimmt, die nicht nur frequenzabhängig sind, sondern die auch nicht reflexionsfrei abgeschlossene Messeingänge der Zeitbereichsmesseinrichtung 34 berücksichtigen.

Bei der im Zeitbereich anschließend durchzuführenden Messung werden nur die Größen $v_3(t)$ und $v_4(t)$ und daraus die Wellengrößen $b_3$ und $b_4$ bestimmt, aus ihnen soll dann auf Wellengrößen bzw. Spannung u(t) und Strom i(t) in der Kalibrierebene 14 geschlossen werden.

Für die beiden Fehlerzweitore, die durch die Fehlermatrizen **I** und **E** beschrieben sind, kann aus den Signalflussdiagrammen der Fig. 3 folgende Beziehung unter Verwendung des Reflexionsfaktors $\Gamma$ in der Kalibrierebene hergeleitet werden:

$$\tilde{S}_{11} = \frac{b_1}{a_1} = i_{00} + \frac{i_{10}i_{01} \cdot \Gamma}{1 - i_{11} \cdot \Gamma},$$

$$\frac{\tilde{S}_{41}}{\tilde{S}_{31}} = \frac{b_4}{b_3} = e_{00} + \frac{e_{10}e_{01} \cdot \Gamma}{1 - e_{11} \cdot \Gamma}. \qquad (1)$$

Hierbei bezeichnet $\widetilde{S_{xy}}$ die vom NWA 26 messbaren Streuparameter. Werden nun drei Kalibrierstandards mit verschiedenen bekannten Reflexionsfaktoren $\Gamma_k$ in der Kalibrierebene angeschlossen, so lassen sich aus diesen Gleichungen jeweils lineare Gleichungssysteme herleiten, um die Fehlerkoeffizienten $e_{00}$, $i_{00}$, $e_{11}$, $i_{11}$, $e_{10}e_{01}$, $i_{10}i_{01}$ zu bestimmen. Verwendet man als Kalibrierstandards einen Leerlauf (Open, O) mit dem Reflexionsfaktor $\Gamma_O$, einen Kurzschluss (Short, S) mit dem Reflexionsfaktor $\Gamma_S$ und einen reflexionsfreien Abschluss (Match, M = 0) mit dem Reflexionsfaktor $\Gamma_M$=0, so ergibt sich die bekannte OSM-Kalibrierung:

$$i_{00} = \tilde{S}_{11,M},$$

$$e_{00} = \frac{\tilde{S}_{41,M}}{\tilde{S}_{31,M}},$$

$$i_{10}i_{01} = \frac{(\Gamma_O - \Gamma_S)(\tilde{S}_{11,O} - \tilde{S}_{11,M})(\tilde{S}_{11,S} - \tilde{S}_{11,M})}{\Gamma_O\Gamma_S(\tilde{S}_{11,O} - \tilde{S}_{11,S})}, \qquad (2)$$

$$e_{10}e_{01} = \frac{(\Gamma_O - \Gamma_S)(\frac{\tilde{S}_{41,O}}{\tilde{S}_{31,O}} - \frac{\tilde{S}_{41,M}}{\tilde{S}_{31,M}})(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

$$i_{11} = \frac{\Gamma_S(\tilde{S}_{11,O} - \tilde{S}_{11,M}) - \Gamma_O(\tilde{S}_{11,S} - \tilde{S}_{11,M})}{\Gamma_O\Gamma_S(\tilde{S}_{11,O} - \tilde{S}_{11,S})},$$

$$e_{11} = \frac{\Gamma_S(\frac{\tilde{S}_{41,O}}{\tilde{S}_{31,O}} - \frac{\tilde{S}_{41,M}}{\tilde{S}_{31,M}}) - \Gamma_O(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

wobei die $\widetilde{S_{xy,K}}$ die mit dem Kalibrierstandard K gemessenen Streuparameter bezeichnen.

Die Kenntnis dieser Terme genügt, um den Reflexionsfaktor $r_{DUT}=a_2/b_2$ eines Messobjekts ("device under test") in der Kalibrierebene aus dem Verhältnis der gemessenen Wellengrößen $b_4/b_3$ zu bestimmen. Hierfür gilt:

$$\Gamma_{DUT} = \frac{\frac{b_4}{b_3} - e_{00}}{e_{10} \cdot e_{01} + e_{11}\left(\frac{b_4}{b_3} - e_{00}\right)} \qquad (3)$$

Für eine Bestimmung der absoluten Wellengrößen $a_2$ und $b_2$ aus $b_3$ und $b_4$ ist jedoch die Zerlegung des Produkts $e_{10}e_{01}$ in seine Faktoren nötig. Dazu wird die Kalibrierung im Folgenden erweitert. Hierbei ist zunächst festzustellen, dass die durch die mathematische Operation der Viertor-Zweitor-Reduktion entstandene Fehlermatrix **E** kein reziprokes Zweitor beschreibt, d. h. es gilt $e_{10} \neq e_{01}$. Hingegen beschreibt die Fehlermatrix **I** den Zusammenhang zwischen dem Messtor S1 des NWA 26 und der Kalibrierebene 14, S2 und kann somit als reziprok angenommen werden. Damit gilt:

$$i_{10} = i_{01} = \pm\sqrt{i_{10} \cdot i_{01}} \qquad (4)$$

Die Entscheidung bezüglich des korrekten Vorzeichens in Gleichung (4) ist äquivalent zur korrekten Bestimmung der Phase von $i_{10}$ aus zwei Möglichkeiten. Hierzu wird wie folgt vorgegangen: Die Phase an einem Frequenzpunkt wird als hinreichend genau bekannt vorausgesetzt, um darüber die Vorzeichenentscheidung zu treffen. Dies kann beispielsweise über eine Abschätzung der elektrischen Länge des Aufbaus zwischen dem Messtor S1 des NWA 26 und der Kalibrierebene S2, 14 geschehen. Es wird weiterhin davon ausgegangen, dass sich die Phase zwischen zwei benachbarten Frequenzpunkten um weniger als 90° ändert. Somit kann auch die korrekte Phase von $i_{10}$ für alle Frequenzpunkte bestimmt werden. Aus den Graphen in den Figuren 3a und 3b können folgende Beziehungen für $b_2$ hergeleitet werden:

$$b_2 = \frac{i_{10}a_1}{1 - i_{11}\Gamma_{DUT}} \qquad (5)$$

$$b_2 = \frac{e_{10}b_3}{1 - e_{11}\Gamma_{DUT}}$$

Da beide Gleichungen dieselbe Wellengröße beschreiben, ergibt sich daraus

$$e_{10} = i_{10} \cdot \frac{a_1}{b_3} \cdot \frac{1 - e_{11}\Gamma_{DUT}}{1 - i_{11}\Gamma_{DUT}} \qquad (6)$$

Hierbei ist $\frac{a_1}{b_3} = \tilde{S}_{31}^{-1}$, so dass $e_{10}$ und daraus mit (2) auch $e_{01}$ einzeln bestimmt werden können. Mit (3), (5) und der aus dem Signalflussgraphen gemäß Fig. 3 herleitbaren Beziehung

$$a_2 = \frac{b_4 - e_{00}b_3}{e_{01}} \qquad (7)$$

können nun, nach Bestimmung der vier Koeffizienten der Fehlermatrix **E** aus gemessenen $b_3$ und $b_4$ die absoluten Wellengrößen $a_2$ und $b_2$ in der Kalibrierebene 14 für eine reflexionsfrei abgeschlossene Zeitbereichsmesseinrichtung bestimmt werden.

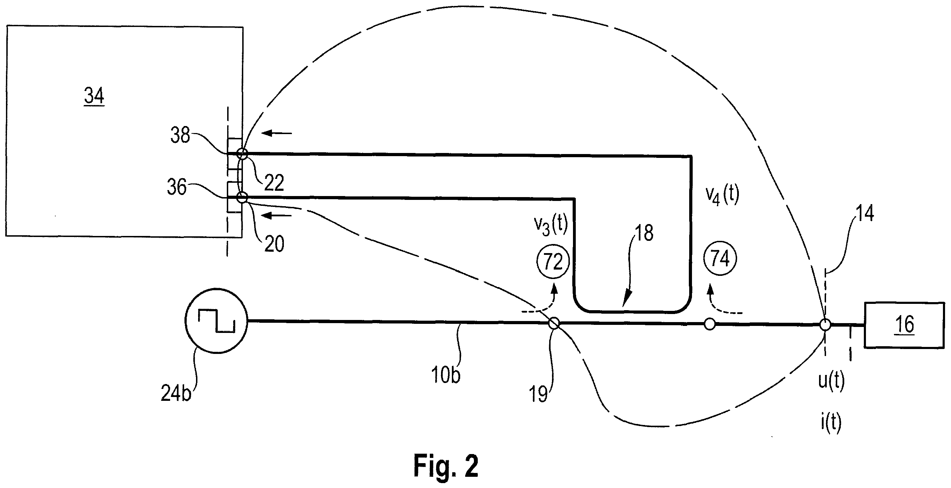

Zeitbereichsmesseinrichtungen 34 wie etwa Oszilloskope sind jedoch im Allgemeinen nicht perfekt reflexionsfrei abgeschlossen. Vielmehr können sie an ihren Messeingängen 36, 38, in die bei dem in Fig. 2 gezeigten Messschritt die Signalanteile 72, 74 einlaufen, Reflexionsfaktoren $\Gamma_3{\neq}0$ und/oder $\Gamma_4{\neq}0$ aufweisen. Die oben beschriebenen Einträge $e_{xy}$ der (unkorrigierten) Fehlermatrix **E** wurden unter der Annahme einer reflexionsfrei abgeschlossenen Zeitbereichsmesseinrichtung 34 bestimmt, so dass keine exakten Spannungen und/oder Ströme in der Kalibrierebene ermittelbar sind, falls eine Zeitbereichsmesseinrichtung 34 mit $\Gamma_3{\neq}0$ und/oder $\Gamma_4{\neq}0$ verwendet wird.

In der nun folgenden Beschreibung wird das Vorgehen zur Bestimmung der korrigierten Kalibrierparameter $\begin{pmatrix} e_{00,r} & e_{01,r} \\ e_{10,r} & e_{11,r} \end{pmatrix}$ der korrigierten Fehlermatrix $\mathbf{E_r}$ unter Rückgriff auf die oben beschriebene (unkorrigierte) Fehlermatrix **E** beschrieben, wobei bei dem erfindungsgemäßen Verfahren die korrigierten Kalibrierparameter $e_{xy,r}$ zum Einsatz kommen.

Gegeben ist das Viertor nach Abbildung 3a, beschrieben durch seine Streumatrix **S**. Stellt dieses Viertor den Richtkoppler 18 samt Zuleitungen dar, so ist der Signaleingang 19 des Richtkopplers 18 während der Kalibrierung mit dem Messtor S1 28 des Netzwerkanalysators 26 und während der Messung beispielsweise mit einer Signalquelle 24 verbunden. Die Messausgänge 20 und 22 des Viertors/Richtkopplers 18 sind während der Kalibrierung mit den Messtoren S3 und S4 des NWAs 26 und während der Messung mit den Messeingängen 36, 38 der Zeitbereichsmesseinrichtung 34 verbunden. Mit Tor S2 des Viertors, der Kalibrierebene 14, werden während der Kalibrierung die Kalibrierstandards und während der Messung das zu vermessende Messobjekt 16 verbunden. Daher ist es Aufgabe des Kalibrierverfahrens, den Zusammenhang zwischen den messbaren Wellengrößen $b_3$ und $b_4$ und den Wellengrößen $a_2$ und $b_2$ in der Kalibrierebene 14 zu bestimmen. Dieser Zusammenhang kann, wie bereits oben erläutert, als - physikalisch nicht vorhandenes - Zweitor mit der Fehlermatrix **E** gemäß Figur 3a dargestellt werden:

$$\begin{pmatrix} b_4 \\ b_2 \end{pmatrix} = \begin{pmatrix} e_{00} & e_{01} \\ e_{10} & e_{11} \end{pmatrix} \begin{pmatrix} b_3 \\ a_2 \end{pmatrix} \qquad (8)$$

Wie bereits oben gezeigt, können alle vier Streuparameter bzw. Fehlerterme $e_{xy}$ dieses Fehlerzweitors durch die Kalibrierung ohne explizite Kenntnis der Streumatrix **S** des zugrundeliegenden Viertors bestimmt werden. Im Folgenden soll dennoch der Zusammenhang zwischen den beiden Matrizen **E** und **S** hergeleitet werden. Unter der Annahme, dass an den Messstellen S3 und S4, mit denen die Messausgänge des Richtkopplers verbunden sind, Reflexionsfaktoren

$\Gamma_3$ bzw. $\Gamma_4$ auftreten, lassen sich folgende sechs Gleichungen aufstellen:

$$\begin{pmatrix} b_1 \\ b_2 \\ b_3 \\ b_4 \end{pmatrix} = \mathbf{S} \begin{pmatrix} a_1 \\ a_2 \\ a_3 \\ a_4 \end{pmatrix} = \begin{pmatrix} S_{11} & S_{12} & S_{13} & S_{14} \\ S_{21} & S_{22} & S_{23} & S_{24} \\ S_{31} & S_{32} & S_{33} & S_{34} \\ S_{41} & S_{42} & S_{43} & S_{44} \end{pmatrix} \begin{pmatrix} a_1 \\ a_2 \\ a_3 \\ a_4 \end{pmatrix},$$
$$a_3 = \Gamma_3 b_3,$$
$$a_4 = \Gamma_4 b_4. \tag{9}$$

Oben war davon ausgegangen worden, dass auch für die Zeitbereichsmesseinrichtung 34 $\Gamma_3 = \Gamma_4 = 0$ gilt. Unter dieser Annahme ergibt sich aus Gleichung (9) die (unkorrigierte) Fehlermatrix **E** wie folgt (Viertor-Zweitor-Reduktion):

$$\begin{pmatrix} b_4 \\ b_2 \end{pmatrix} = \begin{pmatrix} e_{00} & e_{01} \\ e_{10} & e_{11} \end{pmatrix} \begin{pmatrix} b_3 \\ a_2 \end{pmatrix} = \begin{pmatrix} \dfrac{S_{41}}{S_{31}} & \dfrac{S_{31}S_{42} - S_{32}S_{41}}{S_{31}} \\ \dfrac{S_{21}}{S_{31}} & \dfrac{S_{22}S_{31} - S_{21}S_{32}}{S_{31}} \end{pmatrix} \begin{pmatrix} b_3 \\ a_2 \end{pmatrix} \tag{10}$$

Muss hingegen, wie z. B. bei der Messung mit einem Oszilloskop, davon ausgegangen werden, dass $\Gamma_3 \neq 0$ und/oder $\Gamma_4 \neq 0$ gilt, so ergeben sich folgende Gleichungen für die Fehlerterme $e_{xy,r}$, die diese Reflexionsfaktoren berücksichtigen:

$$e_{00,r} = \xi \cdot \left[ S_{41} - \Gamma_3 S_{33} S_{41} + \Gamma_3 S_{31} S_{43} \right],$$
$$e_{01,r} = \xi \cdot \left[ S_{31} S_{42} - S_{32} S_{41} \right],$$

$$\begin{aligned} e_{10,r} = \xi \cdot \Big[ &\Gamma_4 S_{24} S_{41} + \Gamma_3 (\Gamma_4 S_{24}(S_{31} S_{43} - S_{33} S_{41}) \\ &+ S_{23}(S_{31} + \Gamma_4 S_{34} S_{41} - \Gamma_4 x S_{31} S_{44})) \\ &+ S_{21}(1 - \Gamma_4 S_{44} - \Gamma_3(S_{33} + \Gamma_4 S_{34} S_{43} - \Gamma_4 S_{33} S_{44})) \Big], \end{aligned} \tag{11}$$

$$\begin{aligned} e_{11,r} = \xi \cdot \Big[ &\Gamma_4 S_{24}(-S_{32} S_{41} + S_{31} S_{42}) + S_{22}(S_{31} + \Gamma_4 S_{34} S_{41} - \Gamma_4 S_{31} S_{44} \\ &- S_{21}(S_{32} + \Gamma_4 S_{34} S_{42} - \Gamma_4 S_{32} S_{44}) \Big] \end{aligned}$$

$$\text{mit } \xi = \frac{1}{S_{31} + \Gamma_4 S_{34} S_{41} - \Gamma_4 S_{31} S_{44}}.$$

Sind die Streuparameter $S_{xy}$ des Viertors bekannt, so können folglich Kalibrierparameter berechnet werden, die beliebige bekannte Fehlanpassungen $\Gamma_x$ an den Messeingängen der Zeitbereichsmesseinrichtung 34 berücksichtigen. Im folgenden Abschnitt wird dargestellt, wie diese Streuparameter $S_{xy}$ während der Kalibrierung des Richtkopplers 18 ohne zusätzliche Kalibrierschritte oder -standards gewonnen werden können.

Die Streuparameter des Viertors nach Figur 4a können nicht durch eine direkte Messung bestimmt werden, da die Kalibrierebene - zugleich das Tor S2 des Viertors - nicht mit dem NWA verbunden ist. Wird allerdings ein reziprokes Viertor vorausgesetzt, können diese Parameter dennoch bestimmt werden. Es kann ausgenutzt werden, dass während der Kalibrierung Kalibrierstandards mit bekanntem Reflexionsfaktor $\Gamma_{DUT}$ in der Kalibrierebene vorhanden sind. Der Kalibrierstandard, mit dem die folgende Rechnung ausgeführt wird, kann dabei beliebig gewählt werden, es gilt also wahlweise $\Gamma_{DUT} = \Gamma_O$, $\Gamma_{DUT} = \Gamma_S$ oder $\Gamma_{DUT} = \Gamma_M$. Wird außerdem angenommen, dass außer der Kalibrierebene S2 alle anderen Tore des Viertors S1, S3, S4 während der Kalibrierung reflexionsfrei abgeschlossen sind, gilt bei Speisung über das Tor S1:

$$a_2 = \Gamma_{DUT} b_2 = \Gamma_{DUT}(S_{22} a_2 + S_{21} a_1) = \frac{\Gamma_{DUT} S_{21} a_1}{1 - \Gamma_{DUT} S_{22}}. \tag{12}$$

Wird nun mit dem NWA beispielsweise $b_3/a_1$ gemessen, so handelt es sich dabei nicht um den Streuparameter $S_{31}$ des Viertors, da die dafür notwendige Bedingung $a_2=0$ im Allgemeinen nicht gegeben ist. Daher werden die vom NWA gemessenen Größen als $\widetilde{S_{xy}} = \dfrac{b_y}{a_x}$ bezeichnet, um sie von den Streuparametern $S_{xy}$ des Viertors abzugrenzen. Um die oben beschriebene nachträgliche Korrektur der Fehlerterme um bekannte Reflexionsfaktoren vornehmen zu können, müssen die "wahren" Streuparameter des Viertors $S_{xy}$ aus den Messungen des NWAs $\widetilde{S_{xy}} = \dfrac{b_y}{a_x}$ bestimmt werden. Weiterhin können die bereits bestimmten Fehler koeffizienten $e_{xy}$ und $i_{xy}$ verwendet werden. Wird die Definition der Fehlermatrix **I** nach Figur 3b mit dem Viertor **S** verglichen, so ergibt sich

$$
\begin{aligned}
S_{11} &= i_{00}\\
S_{21} &= i_{10}\\
S_{12} &= i_{01}\\
S_{22} &= i_{11}
\end{aligned}
\qquad (13)
$$

Ferner ergibt sich bei Speisung an Tor S1 ($a_3=a_4=0$) mit den Gleichungen (12), (13) und einem Vergleich der $e_{xy}$ gemäß Gleichung (2) und Gleichung (10):

$$
\begin{aligned}
S_{23} = S_{32} &= \frac{-(e_{11}-i_{11})(\Gamma_{\text{DUT}}i_{11}-1)\tilde{S}_{31}}{(e_{11}\Gamma_{\text{DUT}}-1)i_{10}},\\[4pt]
S_{24} = S_{42} &= \frac{(\Gamma_{\text{DUT}}i_{11}-1)(e_{01}i_{10}+(i_{11}-e_{11})\tilde{S}_{41})}{(e_{11}\Gamma_{\text{DUT}}-1)i_{10}},\\[4pt]
S_{13} = S_{31} &= \tilde{S}_{31} - \frac{\Gamma_{\text{DUT}}i_{10}}{1-\Gamma_{\text{DUT}}i_{11}}S_{32},\\[4pt]
S_{14} = S_{41} &= \tilde{S}_{41} - \frac{\Gamma_{\text{DUT}}i_{10}}{1-\Gamma_{\text{DUT}}i_{11}}S_{42}.
\end{aligned}
\qquad (14)
$$

Unter der Annahme, dass das Viertor nun über das Tor S3 gespeist wird und die Tore S1, S4 reflexionsfrei abgeschlossen sind, lässt sich ferner angeben:

$$
\begin{aligned}
b_3 &= S_{33}a_3 + S_{32}a_2,\\[4pt]
a_2 &= \Gamma_{\text{DUT}}b_2 = \Gamma_{\text{DUT}}(S_{22}a_2 + S_{23}a_3) = \frac{\Gamma_{\text{DUT}}S_{23}}{1-\Gamma_{\text{DUT}}S_{22}} \cdot a_3,\\[4pt]
\tilde{S}_{33} &= \left.\frac{b_3}{a_3}\right|_{a_2\neq0} = S_{33} + \frac{\Gamma_{\text{DUT}}S_{23}}{1-\Gamma_{\text{DUT}}S_{22}} \cdot S_{32},\\[4pt]
S_{33} &= \tilde{S}_{33} - \frac{\Gamma_{\text{DUT}}S_{23}}{1-\Gamma_{\text{DUT}}i_{11}} \cdot S_{32}.
\end{aligned}
\qquad (15)
$$

Ebenso lassen sich $S_{44}$ und $S_{34}$ des Viertors herleiten, wenn analog eine Speisung über das Tor S4 betrachtet wird:

$$
\begin{aligned}
S_{44} &= \tilde{S}_{44} - \frac{\Gamma_{\text{DUT}}S_{24}}{1-\Gamma_{\text{DUT}}i_{11}} \cdot S_{42},\\[4pt]
S_{43} = S_{34} &= \tilde{S}_{34} - \frac{\Gamma_{\text{DUT}}S_{24}}{1-\Gamma_{\text{DUT}}i_{11}} \cdot S_{32}.
\end{aligned}
\qquad (16)
$$

Damit sind alle 16 Streuparameter $S_{xy}$ im Rahmen der Kalibrierung bestimmt, ohne dass eine direkte Verbindung zwischen der Kalibrierebene S2 und dem NWA 26 bestehen musste. Mit den Gleichungen (11) können so die korrigierten Kalibrierparameter $e_{xy,r}$ bestimmt werden, die beliebige bekannte Fehlanpassungen während der Messung berücksichtigen.

Im Folgenden wird der Messschritt zur Bestimmung der elektrischen Spannung u(t) und des elektrischen Stroms i(t) des HF-Signals in der Kalibrierebene (14) des erfindungsgemäßen Verfahrens beschrieben.

Figur 2 zeigt den Aufbau zur Messung der Spannung u(t) und des Stroms i(t) in der Kalibrierebene 14 aus den Messwerten eines Oszilloskops oder einer anderen Zeitbereichsmesseinrichtung 34 $v_3$(t) 72 sowie $v_4$(t) 74 in einer Messebene. Hierbei sind die Messeingänge 36, 38 der Zeitbereichsmesseinrichtung 34 mit den Messausgängen 20 und 22 des Richtkopplers 18 verbunden, und mit dem Signaleingang 19 des Richtkopplers 18 ist über eine ggf. geänderte Zuleitung 10b eine beliebige Signalquelle 24b verbunden.

Die Anwendung der Kalibrierparameter $e_{xy,r}$ wird im Folgenden erklärt. Es ist hervorzuheben, dass nur der markierte (gestrichelt umrahmte) Teil des Aufbaus gegenüber der Kalibrierung unverändert sein muss. Dies betrifft im Wesentlichen den Richtkoppler 18 bis zur Kalibrierebene 14 sowie die Leitungen, die den Richtkoppler 18 mit der Zeitbereichsmesseinrichtung 34 verbinden. Änderungen - auch des Wellenwiderstands - der sonstigen Elemente, beispielsweise der Quelle und der Last, haben hingegen keinen Einfluss auf die Messung. Es wird davon ausgegangen, dass sich der Aufbau zwischen der Kalibrierebene 14 und den Messeingängen 36, 38 bzw. den Messausgängen 20, 22 des Richtkopplers 18 gegenüber der Kalibrierung gemäß Fig. 1 nicht ändert, damit die gewonnenen Kalibrierkoeffizienten gültig bleiben. Änderungen an der Signalquelle 24b und deren Zuleitung 10b zum Richtkoppler haben hingegen keinen Einfluss auf die Kalibrierung.

Zur Anwendung der im Frequenzbereich definierten Fehlermatrix **$E_r$** werden die vom Oszilloskop im Zeitbereich erfassten Spannungen $v_3$(t) und $v_4$(t) in die entsprechenden Größen $V_3$(f) und $V_4$(f) im Frequenzbereich transformiert. Hierzu wird in der folgenden Darstellung die schnellen Fouriertransformation (FFT) verwendet. Um die bei Messungen mit hoher Abtastrate auftretenden großen Datenmengen blockweise mit einstellbarer Zeit- und Frequenzauflösung auswerten zu können, kann alternativ auch die Kurzzeit-Fouriertransformation (STFT) zum Einsatz kommen. Da durch die Messung im Zeitbereich inhärent die Phaseninformation zwischen allen spektralen Komponenten erhalten bleibt, ist dieser Aufbau nicht auf die Messung monofrequenter oder periodischer Signale beschränkt.

Die gemessenen Spannungen werden - ggf. durch Interpolation - als zeitdiskrete Vektoren $\{v_3(k \cdot \Delta t)\}$ bzw. $\{v_4(k \cdot \Delta t)\}$ mit einer zeitlichen Schrittweite $\Delta t = 0{,}5/f_{max}$ dargestellt, wobei $f_{max}$ die maximale Frequenz bezeichnet, für die Kalibrierdaten vorliegen und k = 0,1,...,N-1 ein Laufindex über alle N Datenpunkte ist. Diese Vektoren werden mit Hilfe der schnellen Fourier-Transformation (FFT) in den Frequenzbereich überführt und dann als $V_3$(f) und $V_4$(f) bezeichnet:

$$\{V_3(l \cdot \Delta f)\} = FFT\{v_3(k \cdot \Delta t)\} \qquad (15)$$

$$\{V_4(l \cdot \Delta f)\} = FFT\{v_4(k \cdot \Delta t)\} \qquad (16)$$

$$mit\ k = 0,1,\dots,N-1$$

$$und\ l = 0,1,\dots,\frac{N-1}{2}.$$

Da es sich bei den gemessenen Spannungen um reelle Größen handelt, ist die Betrachtung der Spektralanteile für $f \geq 0$ ausreichend. Es ergibt sich eine Frequenzschrittweite $\Delta f = 2f_{max}/(N - 1)$. Die Kalibrierkoeffizienten $e_{xy,r}$ werden durch Interpolation in dasselbe Frequenzraster gebracht.

Bei bekannten Reflexionsfaktoren $\Gamma_3$, $\Gamma_4$ der Messeingänge 36, 38 der Zeitbereichsmesseinrichtung 34 ergibt sich für jeden Frequenzpunkt der folgende Zusammenhang zwischen den Spannungen $V_3$ und $V_4$ und den Wellengrößen $b_3$ und $b_4$:

$$b_3 = \frac{V_3}{(1+\Gamma_3)\sqrt{Z_0}} \qquad (17)$$

$$b_4 = \frac{V_4}{(1+\Gamma_4)\sqrt{Z_0}}, \qquad (18)$$

wobei $Z_0$ die Impedanz bezeichnet, bezüglich derer die Reflexionsfaktoren $\Gamma_3$, $\Gamma_4$ bestimmt wurden. Da während der Kalibrierung $\Gamma_3 = \Gamma_4 = 0$ vorausgesetzt wurde, bestimmt die Systemimpedanz des kalibrierten NWA die Impedanz $Z_0$.

Üblicherweise ist $Z_0$ daher 50 $\Omega$.

Aus diesen Wellengrößen werden mithilfe der Kalibrierparameter ($e_{00,r}(\Gamma_3, \Gamma_4)$, $e_{01,r}(\Gamma_3, \Gamma_4)$, $e_{10,r}(\Gamma_3, \Gamma_4)$, $e_{11,r}(\Gamma_3, \Gamma_4)$) mithilfe der Gleichungen (3), (5) und (7), wobei $e_{xy}$ jeweils durch $e_{xy,r}(\Gamma_3, \Gamma_4)$ ersetzt wird, die absoluten Wellengrößen $a_2$, $b_2$ in der Kalibrierebene bestimmt und daraus die Spannung $V_2$ und der Strom $I_2$ in der Kalibrierebene:

$$V_2 = \sqrt{Z_1}\,(a_2 + b_2) \qquad\qquad (19)$$

$$I_2 = \sqrt{\frac{1}{Z_1}}\,(a_2 - b_2), \qquad\qquad (20)$$

wobei $Z_1$ die Systemimpedanz in der Kalibrierebene bezeichnet. Dabei handelt es sich um die Impedanz, die während der Kalibrierung der Angabe der Reflexionsfaktoren $\Gamma_{O,S,M}$ der Kalibrierstandards zu Grunde lag. Hierbei muss es sich nicht um die physikalische Leitungsimpedanz in der Kalibrierebene 14 handeln. Eine beliebige, jedoch zwischen Kalibrierung und Messung konsistente Wahl von $Z_1$ hat keinen Einfluss auf das Messergebnis. Mit Hilfe der inversen FFT (IFFT) kann aus $V_2(f)$ und $I_2(f)$ die zeitdiskrete Darstellung der Spannung u(t) und des Stroms i(t) in der Kalibrierebene gewonnen werden:

$$\{u(k \cdot \Delta t)\} = IFFT\{V_2(l \cdot \Delta f)\}, \qquad\qquad (21)$$

$$\{i(k \cdot \Delta t)\} = IFFT\{I_2(l \cdot \Delta f)\} \quad . \qquad\qquad (22)$$

$$mit\ k = 0,1,\dots,N-1$$

$$und\ l = 0,1,\dots,\frac{N-1}{2}.$$

Auch hierbei konnte ausgenutzt werden, dass es sich bei der resultierenden Spannung und dem resultierenden Strom um reelle Größen handelt, so dass ausschließlich die Frequenzanteile f>0 als Eingangsgrößen für die IFFT benötigt werden.

Um zu verifizieren, dass mithilfe der Kalibrierparameter $e_{xy,r}$ die Spannung u(t) und der Strom i(t) in der Kalibrierebene 14 auch bei nicht-ideal abgeschlossenen Messeingängen bei der Zeitbereichsmessung exakt bestimmt werden können, wurde eine Simulation mit der Software "Agilent ADS" vorgenommen. Bei der Messung kam ein Leitungskoppler als Richtkoppler 18 zum Einsatz. Der Kalibrierschritt wurde mit einem idealen 50 $\Omega$-System vorgenommen.

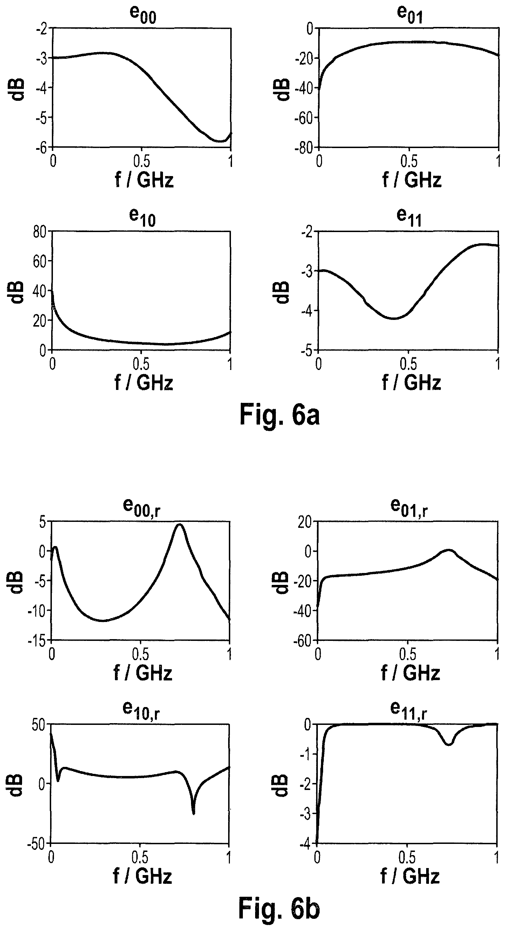

Für die Fehlermatrix $\mathbf{E}=\begin{pmatrix} e_{00} & e_{01} \\ e_{10} & e_{11} \end{pmatrix}$ ergeben sich die in Fig. 6a dargestellten, frequenzabhängigen Werte.

Für die Messung wurde zum 50 $\Omega$-Abschluss an den Messtoren des Richtkopplers hingegen eine Kapazität von 1 nF parallel geschaltet. Daraus ergeben sich in der nachgebildeten Messung frequenzabhängige Reflexionsfaktoren $\Gamma_3=\Gamma_4\neq0$.

Um zunächst die korrekte Bestimmung der Streuparameter $S_{xy}$ mittels der Gleichungen (13) bis (16) zu zeigen, werden die Streuparameter in einer separaten Simulation bestimmt, in der die Kalibrierebene durch ein Tor S2 ersetzt wird. Figur 5 zeigt die perfekte Übereinstimmung zwischen dieser Referenz und den gemäß den Gleichungen bestimmten 16 Streuparametern des Viertors. Daher können die Streuparameter nun verwendet werden, um eine um die Fehlanpassung korrigierte Matrix $\mathbf{E_r}$ zu bestimmen, deren Einträge die Kalibrierparameter $e_{xy,r}$ sind, die in Figur 6b dargestellt sind.

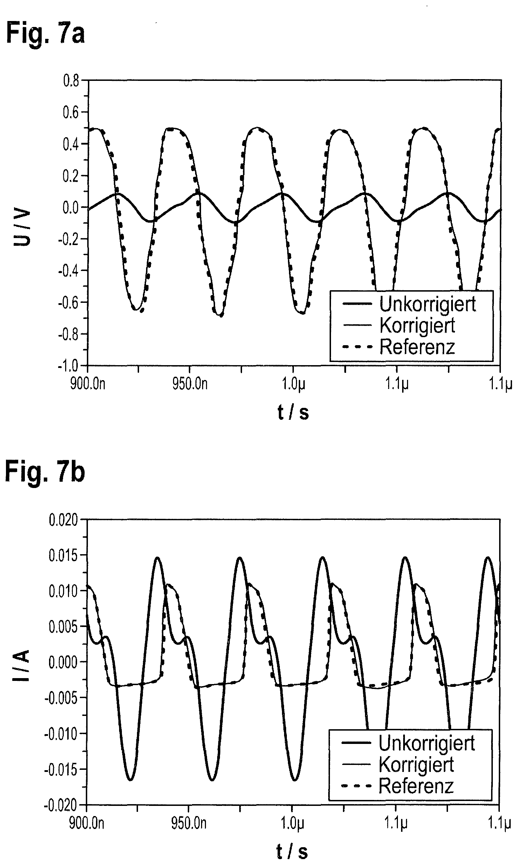

Die Figuren 7a und 7b zeigen die Spannung u(t) und den Strom i(t) in der Kalibrierebene. Es ist zu erkennen, dass bei Verwendung der nicht um die Fehlanpassung korrigierten Kalibrierparameter $e_{xy}$, die in Figur 6a dargestellt sind, weder die Amplitude noch die Form der Verläufe korrekt nachgebildet werden. Hingegen stimmen sowohl Spannung als auch Strom mit der simulatorisch ermittelten Referenz überein, wenn die mittels der erfindungsgemäßen Verfahrens korrigierten Kalibrierparameter $e_{xy,r}$ (siehe Fig. 6b) verwendet werden. Somit konnte verifiziert werden, dass bei entsprechender Korrektur gemäß dem erfindungsgemäßen Verfahren nicht notwendigerweise eine Zeitbereichsmesseinrichtung mit reflexionsfrei abgeschlossenen Messeingängen verwendet werden muss, bzw. dass Reflexionsfaktoren $\Gamma_3\neq0$ und/oder $\Gamma_4\neq0$ korrigiert werden können.

**EP 3 102 961 B1**

**Patentansprüche**

1. Verfahren zum Bestimmen einer elektrischen Spannung u(t) und/oder eines elektrischen Stroms i(t) eines HF-Signals auf einer elektrischen Leitung in einer Kalibrierebene (14) durch Messung im Zeitbereich mit einer Zeitbereichsmesseinrichtung (34), wobei an der Kalibrierebene (14) ein Messobjekt (16) elektrisch anschließbar ist, wobei in einem Messschritt mit einem Richtkoppler (18) ein erster Anteil $v_3(t)$ (72) eines ersten HF-Signals, welches ausgehend von einem Signaleingang (19) in Richtung der Kalibrierebene (14) durch den Richtkoppler (18) läuft, ausgekoppelt, der Zeitbereichsmesseinrichtung (34) an einem ersten Messeingang (36) zugeführt und dort vermessen wird, und ein zweiter Anteil $v_4(t)$ (74) eines zweiten HF-Signals, welches ausgehend von der Kalibrierebene (14) in Richtung des Signaleingangs (19) durch den Richtkoppler (18) läuft, ausgekoppelt, der Zeitbereichsmesseinrichtung (34) an einem zweiten Messeingang (38) zugeführt und dort vermessen wird, wobei die Signalanteile $v_3(t)$ (72), $v_4(t)$ (74) mittels einer ersten mathematischen Operation in den Frequenzraum als Wellengrößen $V_3(f)$ und $V_4(f)$ überführt werden, dann aus den Wellengrößen $V_3(f)$ und $V_4(f)$ unter Verwendung von Kalibrierparametern ($e_{00,r}$, $e_{01,r}$, $e_{10,r}$, $e_{11,r}$) absolute Wellengrößen $a_2$ und $b_2$ im Frequenzraum in der Kalibrierebene (14) bestimmt werden, und schließlich die bestimmten absoluten Wellengrößen $a_2$ und $b_2$ mittels einer zweiten mathematischen Operation in die elektrische Spannung u(t) und/oder den elektrischen Strom i(t) des HF-Signals im Zeitbereich in der Kalibrierebene (14) umgerechnet werden, wobei die Kalibrierparameter die Wellengrößen $V_3(f)$ und $V_4(f)$ mit den absoluten Wellengrößen $a_2$ und $b_2$ in der Kalibrierebene mathematisch verknüpfen, wobei der erste Messeingang (36) der Zeitbereichsmesseinrichtung (34) einen Reflexionsfaktor $\Gamma_3 \# 0$ hat und/oder der zweite Messeingang (38) der Zeitbereichsmesseinrichtung (34) einen Reflexionsfaktor $\Gamma_4 \# 0$ hat, in einem vorausgehenden Kalibrierschritt die Kalibrierparameter ($e_{00,r}$, $e_{01,r}$, $e_{10,r}$, $e_{11,r}$) mithilfe einer Kalibriervorrichtung (26) in Abhängigkeit von der Frequenz f und in Abhängigkeit von einem Kalibrierstandard mit bekanntem Reflexionsfaktor $\Gamma_{DUT}$ an zumindest einem der Messeingänge (36, 38) der Zeitbereichsmesseinrichtung (34) bestimmt werden, und die absoluten Wellengrößen $a_2$ und $b_2$ in dem Messschritt unter Verwendung der Kalibrierparameter ($e_{00,r}(\Gamma_3, \Gamma_4)$, $e_{01,r}(\Gamma_3, \Gamma_4)$, $e_{10,r}(\Gamma_3, \Gamma_4)$, $e_{11,r}(\Gamma_3, \Gamma_4)$) aus den Wellengrößen $V_3(f)$ und $V_4(f)$ bestimmt werden, wobei bei dem Kalibrierschritt der Signaleingang (19) des Richtkopplers (18) mit einem ersten Messtor S1 (28), der erste Messausgang (20) des Richtkopplers (18) mit einem zweiten Messtor S3 (30) und der zweite Messausgang (22) des Richtkopplers (18) mit einem dritten Messtor S4 (32) der Kalibriervorrichtung (26) verbunden werden, wobei an einen mit der Kalibrierebene (14, S2) verbundenen Signalausgang des Richtkopplers (18) ein oder mehrere Messstandards mit bekannten Reflexionsfaktoren angeschlossen werden, wobei die Kalibrierparameter ($e_{00,r}$, $e_{01,r}$, $e_{10,r}$, $e_{11,r}$) eine an dem zweiten Messtor S3 einlaufende Wellengröße $b_3$ und eine an dem dritten Messtor S4 einlaufende Wellengröße $b_4$ wie folgt mit den ein- und auslaufenden absoluten Wellengrößen $b_2$, $a_2$ in der Kalibrierebene (14, S2) verknüpfen:

$$\begin{pmatrix} b_4 \\ b_2 \end{pmatrix} = \begin{pmatrix} e_{00,r} & e_{01,r} \\ e_{10,r} & e_{11,r} \end{pmatrix} \begin{pmatrix} b_3 \\ a_2 \end{pmatrix}$$

wobei die Streuparameter $S_{xy}$ (x=1-4, y=1-4) der Streumatrix **S** des Viertors mit den Toren S1, S2, S3, S4, insbesondere des Richtkopplers (18) samt Zuleitungen, mithilfe der Kalibriereinrichtung (26) bestimmt werden, wobei aus den Streuparametern $S_{xy}$ die Kalibrierparameter ($e_{00,r}$, $e_{01,r}$, $e_{10,r}$, $e_{11,r}$) in Abhängigkeit von den Reflexionsfaktoren der Zeitbereichsmesseinrichtung $\Gamma_3$, $\Gamma_4$($a_3 = \Gamma_3 b_3$, $a_4 = \Gamma_4 b_4$) bestimmt werden, wobei die Kalibrierparameter aus den Streuparametern wie folgt bestimmt werden:

$$e_{00,r} = \frac{S_{41} - \Gamma_3 S_{33} S_{41} + \Gamma_3 S_{31} S_{43}}{S_{31} + \Gamma_4 S_{34} S_{41} - \Gamma_4 S_{31} S_{44}},$$

$$e_{01,r} = \frac{S_{31} S_{42} - S_{32} S_{41}}{S_{31} + \Gamma_4 S_{34} S_{41} - \Gamma_4 S_{31} S_{44}},$$

16

$$e_{10,r} = \frac{\Gamma_4 S_{24} S_{41} + \Gamma_3 (\Gamma_4 S_{24} (S_{31} S_{43} - S_{33} S_{41}) + S_{23} (S_{31} + \Gamma_4 S_{34} S_{41} - \Gamma_4 S_{31} S_{44}))}{S_{31} + \Gamma_4 S_{34} S_{41} - \Gamma_4 S_{31} S_{44}}$$
$$+ \frac{S_{21} (1 - \Gamma_4 S_{44} - \Gamma_3 (S_{33} + \Gamma_4 S_{34} S_{43} - \Gamma_4 S_{33} S_{44}))}{S_{31} + \Gamma_4 S_{34} S_{41} - \Gamma_4 S_{31} S_{44}},$$

$$e_{11,r} = \frac{\Gamma_4 S_{24} (-S_{32} S_{41} + S_{31} S_{42}) + S_{22} (S_{31} + \Gamma_4 S_{34} S_{41} - \Gamma_4 S_{31} S_{44}) - S_{21} (S_{32} + \Gamma_4 S_{34} S_{42} - \Gamma_4 S_{32} S_{44})}{S_{31} + \Gamma_4 S_{34} S_{41} - \Gamma_4 S_{31} S_{44}}.$$

wobei die Streuparameter $S_{xy}$ durch Messung der Wellengrößen $b_1/a_1$, $b_3/a_3$, $b_4/a_4$, $b_3/a_1$ oder $b_1/a_3$, $b_4/a_1$ oder $b_1/a_4$, $b_4/a_3$ oder $b_3/a_4$ an den Messtoren S1, S3, S4 (28, 30, 32) der Kalibriervorrichtung (26) bestimmt werden, wobei jeweils vorzugsweise die Messstandards Match (M), Open (O), Short (S) mit den bekannten Reflexionsfaktoren $\Gamma_M$, $\Gamma_O$, $\Gamma_S$ als Messobjekte an das die Kalibrierebene darstellende Tor S2 angeschlossen werden, wobei $a_1$, $a_3$, $a_4$ an den jeweiligen Messtoren S1, S3, S4 einlaufende Wellengrößen und $b_1$, $b_3$, $b_4$ an den jeweiligen Messtoren S1, S3, S4 auslaufende Wellengrößen sind, und wobei die Streuparameter $S_{xy}$ mittels der folgenden Gleichungen bestimmt werden:

$$S_{11} = i_{00}$$

$$S_{21} = i_{10}$$

$$S_{12} = i_{01}$$

$$S_{22} = i_{11}$$

$$S_{13} = S_{31} = \tilde{S}_{31} - \frac{\Gamma_{DUT} i_{10}}{1 - \Gamma_{DUT} i_{11}} S_{32},$$

$$S_{14} = S_{41} = \tilde{S}_{41} - \frac{\Gamma_{DUT} i_{10}}{1 - \Gamma_{DUT} i_{11}} S_{42}.$$

$$S_{23} = S_{32} = \frac{-(e_{11} - i_{11})(\Gamma_{DUT} i_{11} - 1) \tilde{S}_{31}}{(e_{11} \Gamma_{DUT} - 1) i_{10}},$$

$$S_{24} = S_{42} = \frac{(\Gamma_{DUT} i_{11} - 1)(e_{01} i_{10} + (i_{11} - e_{11}) \tilde{S}_{41})}{(e_{11} \Gamma_{DUT} - 1) i_{10}},$$

$$S_{33} = \tilde{S}_{33} - \frac{\Gamma_{DUT} S_{23}}{1 - \Gamma_{DUT} i_{11}} \cdot S_{32}.$$

$$S_{43} = S_{34} = \tilde{S}_{34} - \frac{\Gamma_{DUT} S_{24}}{1 - \Gamma_{DUT} i_{11}} \cdot S_{32}.$$

$$S_{44} = \tilde{S}_{44} - \frac{\Gamma_{DUT} S_{24}}{1 - \Gamma_{DUT} i_{11}} \cdot S_{42},$$

mit:

$\Gamma_{DUT}$ der bekannte Reflexionsfaktor des bei der Messung jeweils verwendeten Kalibrierstandards,

$\widetilde{S_{xy}}$ die an den Messtoren S1, S3, S4 messbaren $b_x/a_y$ sind,

und:

$$i_{00} = \tilde{S}_{11,M},$$

$$e_{00} = \frac{\tilde{S}_{41,M}}{\tilde{S}_{31,M}},$$

$$i_{10}i_{01} = \frac{(\Gamma_O - \Gamma_S)(\tilde{S}_{11,O} - \tilde{S}_{11,M})(\tilde{S}_{11,S} - \tilde{S}_{11,M})}{\Gamma_O\Gamma_S(\tilde{S}_{11,O} - \tilde{S}_{11,S})},$$

$$e_{10}e_{01} = \frac{(\Gamma_O - \Gamma_S)(\frac{\tilde{S}_{41,O}}{\tilde{S}_{31,O}} - \frac{\tilde{S}_{41,M}}{\tilde{S}_{31,M}})(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

$$i_{11} = \frac{\Gamma_S(\tilde{S}_{11,O} - \tilde{S}_{11,M}) - \Gamma_O(\tilde{S}_{11,S} - \tilde{S}_{11,M})}{\Gamma_O\Gamma_S(\tilde{S}_{11,O} - \tilde{S}_{11,S})},$$

$$e_{11} = \frac{\Gamma_S(\frac{\tilde{S}_{41,O}}{\tilde{S}_{31,O}} - \frac{\tilde{S}_{41,M}}{\tilde{S}_{31,M}}) - \Gamma_O(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

wobei $\Gamma_O$, $\Gamma_S$, $\Gamma_M$ bekannte Reflexionsfaktoren der Kalibrierstandards Open (O), Short (S) und Match (M) sind,

und $\widetilde{S_{xy,K}}$ die an den Messtoren messbaren $b_x/a_y$ bei angeschlossenem Kalibrierstandard K.

2. Verfahren nach Anspruch 1, **dadurch gekennzeichnet, dass** die Signalanteile $v_3(t)$ (72) und/oder $v_4(t)$ (74) eine elektrische Spannung sind.

3. Verfahren nach Anspruch 1 oder 2, **dadurch gekennzeichnet, dass** als Zeitbereichsmesseinrichtung (34) ein Oszilloskop verwendet wird.

4. Verfahren nach einem der vorhergehenden Ansprüche, **dadurch gekennzeichnet, dass** die erste mathematische Operation eine FFT (Fast Fourier Transformation) und/oder die zweite mathematische Operation eine inverse FFT (IFFT - Inverse Fast Fourier Transformation) ist.

5. Verfahren nach einem der vorhergehenden Ansprüche, **dadurch gekennzeichnet, dass** als Kalibriervorrichtung (26) ein vektorieller Netzwerkanalysator (VNA) mit zumindest drei Messtoren (28, 30, 32) verwendet wird.

6. Verfahren nach einem der vorhergehenden Ansprüche, **dadurch gekennzeichnet, dass** bei dem Messschritt zum Messen der zeitvariablen Signalanteile u(t) und i(t) der erste Messausgang (20) des Richtkopplers und der zweite Messausgang (22) des Richtkopplers von der Kalibriervorrichtung (26) getrennt und mit den Messeingängen (36, 38) der Zeitbereichsmesseinrichtung (34) verbunden werden, während über den Signaleingang (19) des Richtkopplers (18) das erste HF-Signal zugeführt wird.

**Claims**

1. Method for determining an electric voltage u(t) and/or an electric current i(t) of a RF signal on an electric cable in a calibration plane (14) through measurement in the time domain using a time domain measuring device (34), wherein a device under test (16) can be connected electrically with the calibration plane (14),

   wherein, in a measuring step, using a directional coupler (18), a first component $v_3(t)$ (72) of a first RF signal which, starting out from a signal input (19), runs in the direction of the calibration plane (14) through the directional coupler (18), is decoupled, fed to the time domain measuring device (34) at a first measuring input and measured there, and a second component $v_4(t)$ (74) of a second RF signal which, starting out from the calibration plane (14), runs in the direction of the signal input (19) through the directional coupler (18), is decoupled, fed to the time domain measuring device (34) at a second measuring input and measured there,

   wherein the signal components $v_3(t)$ (72), $v_4(t)$ (74) are, by means of a first mathematical operation, transformed into the frequency domain as wave quantities $V_3(f)$ and $V_4(f)$, then absolute wave quantities $a_2$ and $b_2$ in the frequency domain are determined in the calibration plane (14) from the wave quantities $V_3(f)$ and $V_4(f)$ using calibration parameters ($e_{00,r}$, $e_{01,r}$, $e_{10,r}$, $e_{11,r}$), and finally the determined absolute wave quantities $a_2$ and $b_2$ are, by means of a second mathematical operation, converted into the electric voltage u(t) and/or the electric current i(t) of the RF signal in the time domain in the calibration plane (14), wherein the calibration parameters link the wave quantities $V_3(f)$ and $V_4(f)$ mathematically with the absolute wave quantities $a_2$ and $b_2$ in the calibration plane, wherein

   the first measuring input (36) of the time domain measuring device (34) has a reflection coefficient $\Gamma_3 \neq 0$ and/or the second measuring input (38) of the time domain measuring device (34) has a reflection coefficient $\Gamma_4 \neq 0$,

   in a preceding calibration step, the calibration parameters ($e_{00,r}$, $e_{01,r}$, $e_{10,r}$, $e_{11,r}$) are determined, with the aid of a calibration device (26), in relation to the frequency f and in relation to a calibration standard with known reflection coefficient $\Gamma_{DUT}$ at at least one of the measuring inputs (36, 38) of the time domain measuring device (34), and the absolute wave quantities $a_2$ and $b_2$ are determined in the measuring step from the wave quantities $V_3(f)$ and $V_4(f)$ using the calibration parameters ($e_{00,r}(\Gamma_3, \Gamma_4)$, $e_{01,r}(\Gamma_3, \Gamma_4)$, $e_{10,r}(\Gamma_3, \Gamma_4)$, $e_{11,r}(\Gamma_3, \Gamma_4)$),

   wherein, during the calibration step the signal input (19) of the directional coupler (18) is connected with a first measuring port S1 (28), the first measuring output (20) of the directional coupler (18) is connected with a second measuring port S3 (30) and the second measuring output (22) of the directional coupler (18) is connected with a third measuring port S4 (32) of the calibration device (26), wherein one or more measuring standards with known reflection coefficients are connected to a signal output of the directional coupler (18) connected with the calibration plane (14, S2),

   wherein the calibration parameters ($e_{00,r}$, $e_{01,r}$, $e_{10,r}$, $e_{11,r}$) link the wave quantity $b_3$ running in at the second measuring port S3 and the wave quantity $b_4$ running in at the third measuring port S4 with the absolute wave quantities $b_2$, $a_2$ running in and out in the calibration plane (14, S2) as follows:

$$\begin{pmatrix} b_4 \\ b_2 \end{pmatrix} = \begin{pmatrix} e_{00,r} & e_{01,r} \\ e_{10,r} & e_{11,r} \end{pmatrix} \begin{pmatrix} b_3 \\ a_2 \end{pmatrix}$$

   wherein the scattering parameters $S_{xy}$ (x=1-4, y=1-4) of the scattering matrix **S** of the four-port with the ports S1, S2, S3, S4, in particular of the directional coupler (18) together with input cables, are determined with the aid of the calibration apparatus (26), wherein the calibration parameters $e_{00,r}$, $e_{01,r}$, $e_{10,r}$, $e_{11,r}$ in relation to the reflection coefficients of the time domain measuring device $\Gamma_3$, $\Gamma_4$ ($a_3 = \Gamma_3 b_3$, $a_4 = \Gamma_4 b_4$) are determined from the scattering parameters $S_{xy}$,

   wherein the calibration parameters are determined from the scattering parameters as follows:

$$e_{00,r} = \frac{S_{41} - \Gamma_3 S_{33} S_{41} + \Gamma_3 S_{31} S_{43}}{S_{31} + \Gamma_4 S_{34} S_{41} - \Gamma_4 S_{31} S_{44}},$$

$$e_{01,r} = \frac{S_{31} S_{42} - S_{32} S_{41}}{S_{31} + \Gamma_4 S_{34} S_{41} - \Gamma_4 S_{31} S_{44}},$$

$$e_{10,r} = \frac{\Gamma_4 S_{24} S_{41} + \Gamma_3(\Gamma_4 S_{24}(S_{31} S_{43} - S_{33} S_{41}) + S_{23}(S_{31} + \Gamma_4 S_{34} S_{41} - \Gamma_4 S_{31} S_{44}))}{S_{31} + \Gamma_4 S_{34} S_{41} - \Gamma_4 S_{31} S_{44}}$$
$$+ \frac{S_{21}(1 - \Gamma_4 S_{44} - \Gamma_3(S_{33} + \Gamma_4 S_{34} S_{43} - \Gamma_4 S_{33} S_{44}))}{S_{31} + \Gamma_4 S_{34} S_{41} - \Gamma_4 S_{31} S_{44}},$$

$$e_{11,r} = \frac{\Gamma_4 S_{24}(-S_{32} S_{41} + S_{31} S_{42}) + S_{22}(S_{31} + \Gamma_4 S_{34} S_{41} - \Gamma_4 S_{31} S_{44}) - S_{21}(S_{32} + \Gamma_4 S_{34} S_{42} - \Gamma_4 S_{32} S_{44})}{S_{31} + \Gamma_4 S_{34} S_{41} - \Gamma_4 S_{31} S_{44}}.$$

wherein the scattering parameters $S_{xy}$ are determined through measurement of the wave quantities $b_1/a_1$, $b_3/a_3$, $b_4/a_4$, $b_3/a_1$ or $b_1/a_3$, $b_4/a_1$ or $b_1/a_4$, $b_4/a_3$ or $b_3/a_4$ at the measuring ports S1, S3, S4 (28, 30, 32) of the calibration device (26), wherein in each case preferably the measuring standards Match (M), Open (O), Short (S) with the known reflection coefficients $\Gamma_M$, $\Gamma_O$, $\Gamma_S$ are connected as devices under test to port S2 which is constituting the calibration plane , where $a_1$, $a_3$, $a_4$ are wave quantities running in at the respective measuring ports S1, S3, S4 and $b_1$, $b_3$, $b_4$ are wave quantities running out at the respective measuring ports S1, S3, S4, and wherein the scattering parameters $S_{xy}$ are determined by means of the following equations:

$$S_{11} = i_{00}$$

$$S_{21} = i_{10}$$

$$S_{12} = i_{01}$$

$$S_{22} = i_{11}$$

$$S_{13} = S_{31} = \tilde{S}_{31} - \frac{\Gamma_{DUT} i_{10}}{1 - \Gamma_{DUT} i_{11}} S_{32},$$

$$S_{14} = S_{41} = \tilde{S}_{41} - \frac{\Gamma_{DUT} i_{10}}{1 - \Gamma_{DUT} i_{11}} S_{42}.$$

$$S_{23} = S_{32} = \frac{-(e_{11} - i_{11})(\Gamma_{DUT} i_{11} - 1)\tilde{S}_{31}}{(e_{11}\Gamma_{DUT} - 1)i_{10}},$$

$$S_{24} = S_{42} = \frac{(\Gamma_{DUT} i_{11} - 1)(e_{01} i_{10} + (i_{11} - e_{11})\tilde{S}_{41})}{(e_{11}\Gamma_{DUT} - 1)i_{10}},$$

$$S_{33} = \tilde{S}_{33} - \frac{\Gamma_{DUT} S_{23}}{1 - \Gamma_{DUT} i_{11}} \cdot S_{32}.$$

$$S_{43} = S_{34} = \tilde{S}_{34} - \frac{\Gamma_{DUT} S_{24}}{1 - \Gamma_{DUT} i_{11}} \cdot S_{32}.$$

$$S_{44} = \tilde{S}_{44} - \frac{\Gamma_{DUT} S_{24}}{1 - \Gamma_{DUT} i_{11}} \cdot S_{42},$$

where:

$\Gamma_{DUT}$ is the known reflection coefficient of the calibration standard used during the measurement,

$\widetilde{S_{xy}}$ are the $b_x/a_y$ measurable at the measuring ports S1, S3, S4

and:

$$i_{00} = \tilde{S}_{11,M},$$

$$e_{00} = \frac{\tilde{S}_{41,M}}{\tilde{S}_{31,M}},$$

$$i_{10}i_{01} = \frac{(\Gamma_O - \Gamma_S)(\tilde{S}_{11,O} - \tilde{S}_{11,M})(\tilde{S}_{11,S} - \tilde{S}_{11,M})}{\Gamma_O\Gamma_S(\tilde{S}_{11,O} - \tilde{S}_{11,S})},$$

$$e_{10}e_{01} = \frac{(\Gamma_O - \Gamma_S)(\frac{\tilde{S}_{41,O}}{\tilde{S}_{31,O}} - \frac{\tilde{S}_{41,M}}{\tilde{S}_{31,M}})(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

$$i_{11} = \frac{\Gamma_S(\tilde{S}_{11,O} - \tilde{S}_{11,M}) - \Gamma_O(\tilde{S}_{11,S} - \tilde{S}_{11,M})}{\Gamma_O\Gamma_S(\tilde{S}_{11,O} - \tilde{S}_{11,S})},$$

$$e_{11} = \frac{\Gamma_S(\frac{\tilde{S}_{41,O}}{\tilde{S}_{31,O}} - \frac{\tilde{S}_{41,M}}{\tilde{S}_{31,M}}) - \Gamma_O(\frac{\tilde{S}_{41,S}}{\tilde{S}_{31,S}} - \frac{\tilde{S}_{41,M}}{\tilde{S}_{31,M}})}{\Gamma_O\Gamma_S(\frac{\tilde{S}_{41,O}}{\tilde{S}_{31,O}} - \frac{\tilde{S}_{41,S}}{\tilde{S}_{31,S}})},$$

where $\Gamma_O$, $F_S$, $\Gamma_M$ are known reflection coefficients of the calibration standards Open (O), Short (S) and Match (M), and $\widetilde{S_{xy,K}}$ are the $b_x/a_y$ measurable at the measuring ports with connected calibration standard K.

2. Method according to claim 1, **characterised in that** the signal components $v_3(t)$ (72) and/or $v_4(t)$ (74) are an electric voltage.

3. Method according to claim 1 or 2, **characterised in that** an oscilloscope is used as the time domain measuring device (34).

4. Method according to one of the preceding claims, **characterised in that** the first mathematical operation is an FFT (Fast Fourier Transform) and/or the second mathematical operation is an inverse FFT (IFFT - Inverse Fast Fourier Transform).

5. Method according to one of the preceding claims, **characterised in that** a vectorial network analyser (VNA) with at least three measuring ports (28, 30, 32) is used as the calibration device (26).

6. Method according to one of the preceding claims, **characterised in that**, during the measuring step, in order to measure the time-variable signal components u(t) and i(t), the first measuring output (20) of the directional coupler and the second measuring output (22) of the directional coupler are isolated from the calibration device (26) and connected with the measuring inputs (36, 38) of the time domain measuring device (34), while the first RF signal is fed via the signal input (19) of the directional coupler (18).

**Revendications**

1. Procédé pour déterminer une tension électrique u(t) et/ou un courant électrique i(t) d'un signal HF sur une ligne électrique dans un plan d'étalonnage (14) par mesure dans le domaine temporel au moyen d'un dispositif (34) de mesure dans le domaine temporel, un objet de mesure (16) pouvant être connecté électriquement au plan d'étalonnage (14),

   dans lequel

   dans une étape de mesure, au moyen d'un coupleur directionnel (18), une première part $v_3(t)$ (72) d'un premier signal HF qui traverse le coupleur directionnel (18) en direction du plan d'étalonnage (14) à partir d'une entrée de signal (19) est découplée, amenée au dispositif (34) de mesure dans le domaine temporel au niveau d'une première entrée de mesure (36) et y est mesurée,

   et une seconde part $v_4(t)$ (74) d'un second signal HF qui traverse le coupleur directionnel (18) en direction de l'entrée de signal (19) à partir du plan d'étalonnage (14) est découplée, amenée au dispositif (34) de mesure dans le domaine temporel au niveau d'une seconde entrée de mesure (38) et y est mesurée,

   les parts de signal $v_3(t)$ (72), $v_4(t)$ (74) sont transposées dans l'espace fréquentiel sous forme de grandeurs d'onde $V_3(f)$ et $V_4(f)$ au moyen d'une première opération mathématique, ensuite, à partir des grandeurs d'onde $V_3(f)$ et $V_4(f)$, on détermine dans l'espace fréquentiel dans le plan d'étalonnage (14) des grandeurs d'onde absolues $a_2$ et $b_2$ en utilisant des paramètres d'étalonnage ($e_{00,r}$, $e_{01,r}$, $e_{10,r}$, $e_{11,r}$), et finalement on convertit les grandeurs d'onde absolues déterminées $a_2$ et $b_2$ au moyen d'une seconde opération mathématique en la tension électrique u(t) et/ou en le courant électrique i(t) du signal HF dans le domaine temporel dans le plan d'étalonnage (14), et les paramètres d'étalonnage établissent un chaînage mathématique des grandeurs d'onde $V_3(f)$ et $V_4(f)$ avec les grandeurs d'onde absolues $a_2$ et $b_2$ dans le plan d'étalonnage, dans lequel

   la première entrée de mesure (36) du dispositif (34) de mesure dans le domaine temporel possède un facteur de réflexion $\Gamma_3 \neq 0$ et/ou la seconde entrée de mesure (38) du dispositif (34) de mesure dans le domaine temporel possède un facteur de réflexion $\Gamma_4 \neq 0$,

   dans une étape d'étalonnage précédente, on détermine les paramètres d'étalonnage ($e_{00,r}$, $e_{01,r}$, $e_{10,r}$, $e_{11,r}$) à l'aide d'un dispositif d'étalonnage (26) en fonction de la fréquence f et en fonction d'un standard d'étalonnage à facteur de réflexion connu $\Gamma_{DUT}$ à l'une au moins des entrées de mesure (36, 38) du dispositif (34) de mesure dans le domaine temporel, et

   on détermine les grandeurs d'onde absolues $a_2$ et $b_2$ dans l'étape de mesure en utilisant les paramètres d'étalonnage ($e_{00,r}$ ($\Gamma_3$, $\Gamma_4$), $e_{01,r}$ ($\Gamma_3$, $\Gamma_4$), $e_{10,r}$ ($\Gamma_3$, $\Gamma_4$), $e_{11,r}$ ($\Gamma_3$, $\Gamma_4$) à partir des grandeurs d'onde $V_3(f)$ et $V_4(f)$,

   et dans l'étape d'étalonnage, on connecte l'entrée de signal (19) du coupleur directionnel (18) à un premier port de mesure S1 (28), on connecte la première sortie de mesure (20) du coupleur directionnel (18) à un second port de mesure S3 (30), et on connecte la seconde sortie de mesure (22) du coupleur directionnel (18) à un troisième port de mesure S4 (32) du dispositif d'étalonnage (26), et on branche un ou plusieurs standards de mesure possédant des facteurs de réflexion connus à une sortie de signal du coupleur directionnel (18) connectée au plan d'étalonnage (14, S2),

   dans lequel les paramètres d'étalonnage ($e_{00,r}$, $e_{01,r}$, $e_{10,r}$, $e_{11,r}$) établissent un chaînage d'une grandeur d'onde $b_3$, entrant dans le second port de mesure S3, et une grandeur d'onde $b_4$, entrant dans le troisième port de mesure S4, avec les grandeurs d'onde absolues $b_2$, $a_2$ entrant et sortant, dans le plan d'étalonnage (14, S2), comme suit :

$$\begin{pmatrix} b4 \\ b2 \end{pmatrix} = \begin{pmatrix} e_{00,r} & e_{01,r} \\ e_{10,r} & e_{11,r} \end{pmatrix} \begin{pmatrix} b3 \\ a2 \end{pmatrix}$$

   dans lequel on détermine les paramètres de répartition $S_{xy}$ (x = 1 - 4, y = 1 - 4) de la matrice de répartition S du "quatre ports" avec les ports S1, S2, S3, S4, en particulier du coupleur directionnel (18), y compris les lignes d'amenée, à l'aide du dispositif d'étalonnage (26), et à partir des paramètres de répartition $S_{xy}$ on détermine les paramètres d'étalonnage ($e_{00,r}$, $e_{01,r}$, $e_{10,r}$, $e_{11,r}$) en fonction des facteurs de réflexion du dispositif de mesure dans le domaine temporel $\Gamma_3$, $\Gamma_4$ ($a_3 = \Gamma_3 b_3$, $a_4 = \Gamma_4 b_4$),

   dans lequel on détermine les paramètres d'étalonnage à partir des paramètres de répartition comme suit :

$$e_{00,r} = \frac{S_{41} - \Gamma_3 S_{33} S_{41} + \Gamma_3 S_{31} S_{43}}{S_{31} + \Gamma_4 S_{34} S_{41} - \Gamma_4 S_{31} S_{44}},$$

$$e_{01,r} = \frac{S_{31}S_{42} - S_{32}S_{41}}{S_{31} + \Gamma_4 S_{34} S_{41} - \Gamma_4 S_{31} S_{44}},$$

$$e_{10,r} = \frac{\Gamma_4 S_{24} S_{41} + \Gamma_3(\Gamma_4 S_{24}(S_{31} S_{43} - S_{33} S_{41}) + S_{23}(S_{31} + \Gamma_4 S_{34} S_{41} - \Gamma_4 S_{31} S_{44}))}{S_{31} + \Gamma_4 S_{34} S_{41} - \Gamma_4 S_{31} S_{44}}$$
$$+ \frac{S_{21}(1 - \Gamma_4 S_{44} - \Gamma_3(S_{33} + \Gamma_4 S_{34} S_{43} - \Gamma_4 S_{33} S_{44}))}{S_{31} + \Gamma_4 S_{34} S_{41} - \Gamma_4 S_{31} S_{44}},$$

$$e_{11,r} = \frac{\Gamma_4 S_{24}(-S_{32} S_{41} + S_{31} S_{42}) + S_{22}(S_{31} + \Gamma_4 S_{34} S_{41} - \Gamma_4 S_{31} S_{44}) - S_{21}(S_{32} + \Gamma_4 S_{34} S_{42} - \Gamma_4 S_{32} S_{44})}{S_{31} + \Gamma_4 S_{34} S_{41} - \Gamma_4 S_{31} S_{44}}.$$

dans lequel on détermine les paramètres de répartition $S_{xy}$ en mesurant les grandeurs d'onde $b_1/a_1$, $b_3/a_3$, $b_4/a_4$, $b_3/a_1$ ou $b_1/a_3$, $b_4/a_1$ ou $b_1/a_4$, $b_4/a_3$ ou $b_3/a_4$ aux ports de mesure S1, S3, S4 (28, 30, 32) du dispositif d'étalonnage (26), et on branche de préférence les standards de mesure "Match (M)", "Open (O)", "Short (S)" avec les facteurs de réflexion connus $\Gamma_M$, $\Gamma_O$, $\Gamma_S$ à titre d'objets de mesure au port S2 représentant le plan d'étalonnage, $a_1$, $a_3$, $a_4$ étant des grandeurs d'onde entrant aux ports de mesure respectifs S1, S3, S4, et $b_1$, $b_3$, $b_4$ étant des grandeurs d'onde sortant aux ports de mesure respectifs S1, S3, S4, et on détermine les paramètres de répartition $S_{xy}$ au moyen des équations suivantes :

$$S_{11} = i_{00}$$

$$S_{21} = i_{10}$$

$$S_{12} = i_{01}$$

$$S_{22} = i_{11}$$

$$S_{13} = S_{31} = \tilde{S}_{31} - \frac{\Gamma_{DUT} i_{10}}{1 - \Gamma_{DUT} i_{11}} S_{32},$$

$$S_{14} = S_{41} = \tilde{S}_{41} - \frac{\Gamma_{DUT} i_{10}}{1 - \Gamma_{DUT} i_{11}} S_{42}.$$

$$S_{23} = S_{32} = \frac{-(e_{11} - i_{11})(\Gamma_{DUT} i_{11} - 1)\tilde{S}_{31}}{(e_{11}\Gamma_{DUT} - 1) i_{10}},$$

$$S_{24} = S_{42} = \frac{(\Gamma_{DUT} i_{11} - 1)(e_{01} i_{10} + (i_{11} - e_{11})\tilde{S}_{41})}{(e_{11}\Gamma_{DUT} - 1) i_{10}}$$

$$S_{33} = \tilde{S}_{33} - \frac{\Gamma_{DUT} S_{23}}{1 - \Gamma_{DUT} i_{11}} \cdot S_{32}.$$

$$S_{43} = S_{34} = \tilde{S}_{34} - \frac{\Gamma_{\mathrm{DUT}} S_{24}}{1 - \Gamma_{\mathrm{DUT}} i_{11}} \cdot S_{32}.$$

$$S_{44} = \tilde{S}_{44} - \frac{\Gamma_{\mathrm{DUT}} S_{24}}{1 - \Gamma_{\mathrm{DUT}} i_{11}} \cdot S_{42},$$

où

$\Gamma_{\mathrm{DUT}}$ est le facteur de réflexion connu du standard d'étalonnage utilisé pour la mesure respective, $\widetilde{S_{xy}}$ sont les $b_x/a_y$ mesurables aux ports de mesure S1, S3, S4 et

$$i_{00} = \tilde{S}_{11,M},$$

$$e_{00} = \frac{\tilde{S}_{41,M}}{\tilde{S}_{31,M}},$$

$$i_{10} i_{01} = \frac{(\Gamma_O - \Gamma_S)(\tilde{S}_{11,O} - \tilde{S}_{11,M})(\tilde{S}_{11,S} - \tilde{S}_{11,M})}{\Gamma_O \Gamma_S (\tilde{S}_{11,O} - \tilde{S}_{11,S})},$$

$$e_{10} e_{01} = \frac{(\Gamma_O - \Gamma_S)(\frac{\tilde{S}_{41,O}}{\tilde{S}_{31,O}} - \frac{\tilde{S}_{41,M}}{\tilde{S}_{31,M}})(\frac{\tilde{S}_{41,S}}{\tilde{S}_{31,S}} - \frac{\tilde{S}_{41,M}}{\tilde{S}_{31,M}})}{\Gamma_O \Gamma_S (\frac{\tilde{S}_{41,O}}{\tilde{S}_{31,O}} - \frac{\tilde{S}_{41,S}}{\tilde{S}_{31,S}})},$$

$$i_{11} = \frac{\Gamma_S(\tilde{S}_{11,O} - \tilde{S}_{11,M}) - \Gamma_O(\tilde{S}_{11,S} - \tilde{S}_{11,M})}{\Gamma_O \Gamma_S (\tilde{S}_{11,O} - \tilde{S}_{11,S})},$$

$$e_{11} = \frac{\Gamma_S(\frac{\tilde{S}_{41,O}}{\tilde{S}_{31,O}} - \frac{\tilde{S}_{41,M}}{\tilde{S}_{31,M}}) - \Gamma_O(\frac{\tilde{S}_{41,S}}{\tilde{S}_{31,S}} - \frac{\tilde{S}_{41,M}}{\tilde{S}_{31,M}})}{\Gamma_O \Gamma_S (\frac{\tilde{S}_{41,O}}{\tilde{S}_{31,O}} - \frac{\tilde{S}_{41,S}}{\tilde{S}_{31,S}})},$$

où

$\Gamma_O$, $\Gamma_S$, $\Gamma M$ sont des facteurs de réflexion connus des standards d'étalonnage "Open (O)", "Short (S)" et "Match (M)", et $\widetilde{S_{xyK}}$ sont les $b_x/a_y$ mesurables, le standard d'étalonnage K étant branché.

2. Procédé selon la revendication 1, **caractérisé en ce que** les parts de signal $v_3(t)$ (72) et/ou $v_4(t)$ (74) sont une tension électrique.

3. Procédé selon la revendication 1 ou 2, **caractérisé en ce que** l'on utilise à titre de dispositif (34) de mesure dans le domaine temporel un oscilloscope.

4. Procédé selon l'une des revendications précédentes, **caractérisé en ce que** la première opération mathématique est une FFT (Fast Fourier Transformation) et/ou la seconde opération mathématique est une FFT inverse (IFFT - Inverse Fast Fourier Transformation).

5. Procédé selon l'une des revendications précédentes, **caractérisé en ce que** l'on utilise à titre de dispositif d'étalonnage (26) un analyseur de réseau vectoriel (VNA) avec au moins trois ports de mesure (28, 30, 32).

6. Procédé selon l'une des revendications précédentes, **caractérisé en ce que** dans l'étape de mesure pour mesurer les parts de signal u(t) et i(t) variables en fonction du temps, on sépare du dispositif d'étalonnage (26) la première sortie de mesure (20) du coupleur directionnel et la seconde sortie de mesure (22) du coupleur directionnel et on les relie aux entrées de mesure (36, 38) du dispositif (34) de mesure dans le domaine temporel, tandis que l'on amène le premier signal HF via l'entrée de signal (19) du coupleur directionnel (18).

Fig. 1

Fig. 2

Fig. 3a

Fig. 3b

Fig. 4a                     Fig. 4b                     Fig. 4c

Fig. 5

Fig. 6a

Fig. 6b

## Fig. 7a

## Fig. 7b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03048791 A2
- WO 2013143650 A1

- WO 2013143650 A
- WO 2008016699 A

**In der Beschreibung aufgeführte Nicht-Patentliteratur**

- **UWE SIART.** *Kalibrierung von Netzwerkanalysatoren,* 04. Januar 2012, http://www.siart.de/lehre/nwa.pdf
- **D. ROOT et al.** X-Parameter: Das neue Paradigma zur Beschreibung nichtlinearer HF- und Mikrowellenbauelemente. *tm - Technisches Messen Nr. 7-8,* 2010, vol. 77

- Calibartion of Sampling Oscilloscopes With High-Speed Photodiodes. **CLEMENT T. S. et al.** IEEE TRANSACTIONS ON MICROWAVE THEORY AND TECHNIQUES. IEEE SERVICE CENTER, 01. August 2006, vol. 54, 3173-3181
- Covariance-Based Vector-Network-Analyzer Uncertainty Analysis for Time and Frequency-Domain Measurements. **ARKADIUSZ LEWANDOWSKI et al.** IEEE TRANSACTIONS ON MICROWAVE THEORY AND TECHNIQUES. IEEE SERVICE CENTER, 01. Juli 2010, vol. 58, 1877-1886